(19) Europäisches Patentamt
European Patent Office
Office européen des brevets

(11) EP 3 503 242 B1

(12) EUROPEAN PATENT SPECIFICATION

(45) Date of publication and mention of the grant of the patent:
**25.08.2021 Bulletin 2021/34**

(51) Int Cl.:
***H01L 51/54*** *(2006.01)*

(21) Application number: **17210292.3**

(22) Date of filing: **22.12.2017**

(54) **SEMICONDUCTING MATERIAL, A METHOD FOR PREPARING THE SAME AND ELECTRONIC DEVICE**

HALBLEITERMATERIAL, VERFAHREN ZUR HERSTELLUNG DAVON UND ELEKTRONISCHE VORRICHTUNG

MATÉRIAU SEMI-CONDUCTEUR, SON PROCÉDÉ DE PRÉPARATION ET DISPOSITIF ÉLECTRONIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**26.06.2019 Bulletin 2019/26**

(73) Proprietor: **Novaled GmbH**
**01099 Dresden (DE)**

(72) Inventors:
- **CADINALI, Francois c/o Novaled GmbH 01307 Dresden (DE)**
- **GANIER, Jerome c/o Novaled GmbH 01307 Dresden (DE)**
- **ROTHE, Carsten c/o Novaled GmbH 01307 Dresden (DE)**
- **SCHULZE, Benjamin c/o Novaled GmbH 01307 Dresden (DE)**

(74) Representative: **Bittner, Thomas L.**
**Boehmert & Boehmert Anwaltspartnerschaft mbB**
**Pettenkoferstrasse 22**
**80336 München (DE)**

(56) References cited:
**EP-A1- 2 786 433 EP-A1- 3 171 418**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 503 242 B1

## Description

The present invention relates to a semiconducting material, a method for preparing the same and an electronic device comprising a semiconducting layer made of the semiconducting material.

BACKGROUND ART

Organic light-emitting diodes (OLEDs), which are self-emitting devices, have a wide viewing angle, excellent contrast, quick response, high brightness, excellent driving voltage characteristics, and color reproduction. A typical OLED includes an anode, a hole transport layer (HTL), an emission layer (EML), an electron transport layer (ETL), and a cathode, which are sequentially stacked on a substrate. In this regard, the HTL, the EML, and the ETL are thin films formed from organic and / or organometallic compounds.

When a voltage is applied to the anode and the cathode, holes injected from the anode electrode move to the EML, via the HTL, and electrons injected from the cathode electrode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has excellent efficiency.

Borate complexes for use in organic electronic devices are known in the prior art, for example from the European patent application EP 2 786 433 A1.

Dialkylphosphine oxide compounds are published, for example, in WO 2017/089399 as suitable compounds for use in organic semiconductive layers, in particular as electron matrix material of organic electronic devices, such as OLEDs.

However, there is still a need to further improve performance of organic electronic devices.

It is, therefore, an object of the present invention to provide novel compounds for use in semiconducting layers of organic electronic devices overcoming drawbacks of the prior art, in particular such compounds suitable to improve the performance of the organic electronic device. In particular, it is an object to provide semiconducting materials showing favorable performance in organic electronic devices in particular improved operational voltage stability at elevated temperatures.

DESCRIPTION OF THE INVENTION

This object is achieved by a semiconducting material comprising: (i) at last one metal complex or metal salt comprising a divalent metal; and (ii) at least one matrix compound comprising a dialkylphosphine oxide group.

It was surprisingly found by the inventors that in comparison with respective materials known in the art, the inventive selection of a metal complex or metal salts comprising a divalent metal with a dialkylphosphine oxide group matrix compound results in an improved semiconducting material having improved operational voltage stability at elevated temperatures.

In the semiconducting material, the metal complex or metal salt may be a borate complex or borate salt comprising at least one borate anion. In this way, fine tuning of the electronic structure of the inventive constituents of the semiconducting material is achieved to improve the usability thereof in semiconducting layers of electronic devices, in particular in the electron transport layer thereof.

In the semiconducting material, the metal complex or metal salt may consist of one divalent metal cation and two monovalent anions. In this way, fine tuning of the electronic structure of the inventive constituents of the semiconducting material is achieved to improve the usability thereof in semiconducting layers of electronic devices, in particular in the electron transport layer thereof.

In the semiconducting material, the metal may form with at least one anion at least one ring, preferably a five-, six- or seven-membered ring. In this way, fine tuning of the electronic structure of the inventive constituents of the semiconducting material is achieved to improve the usability thereof in semiconducting layers of electronic devices, in particular in the electron transport layer thereof.

In the semiconducting material, the metal complex or the metal salt may comprise two borate anions, preferably two borate anions which may be identical. In this way, fine tuning of the electronic structure of the inventive constituents of the semiconducting material is achieved to improve the usability thereof in semiconducting layers of electronic devices, in particular in the electron transport layer thereof.

In the semiconducting material, at least one monovalent anion may comprise at least one heterocyclic group. In this way, fine tuning of the electronic structure of the inventive constituents of the semiconducting material is achieved to improve the usability thereof in semiconducting layers of electronic devices, in particular in the electron transport layer thereof.

In the semiconducting material, the heterocyclic group may be a heteroaryl group, preferably a $C_2$-$C_{30}$ heteroaryl

group. In this way, fine tuning of the electronic structure of the inventive constituents of the semiconducting material is achieved to improve the usability thereof in semiconducting layers of electronic devices, in particular in the electron transport layer thereof.

In the semiconducting material, the heterocyclic group may comprise one or more heteroatoms independently selected from N, O and S. In this way, fine tuning of the electronic structure of the inventive constituents of the semiconducting material is achieved to improve the usability thereof in semiconducting layers of electronic devices, in particular in the electron transport layer thereof.

In the semiconducting material, the heterocyclic group may comprise a five-membered heterocyclic ring. In this way, fine tuning of the electronic structure of the inventive constituents of the semiconducting material is achieved to improve the usability thereof in semiconducting layers of electronic devices, in particular in the electron transport layer thereof.

In the semiconducting material, the heterocyclic group may comprise an azole or a diazole ring. In this way, fine tuning of the electronic structure of the inventive constituents of the semiconducting material is achieved to improve the usability thereof in semiconducting layers of electronic devices, in particular in the electron transport layer thereof.

In the semiconducting material, the heterocyclic group may be a 1,2-diazole group. In this way, fine tuning of the electronic structure of the inventive constituents of the semiconducting material is achieved to improve the usability thereof in semiconducting layers of electronic devices, in particular in the electron transport layer thereof.

In the semiconducting material, the anion may comprise at least two heterocyclic groups. In this way, fine tuning of the electronic structure of the inventive constituents of the semiconducting material is achieved to improve the usability thereof in semiconducting layers of electronic devices, in particular in the electron transport layer thereof.

In the semiconducting material, the divalent metal ion may be selected from $Ca^{2+}$, $Sr^{2+}$ and $Mg^{2+}$. In this way, fine tuning of the electronic structure of the inventive constituents of the semiconducting material is achieved to improve the usability thereof in semiconducting layers of electronic devices, in particular in the electron transport layer thereof.

In the semiconducting material, the metal complex or metal salt may have the following formula (I)

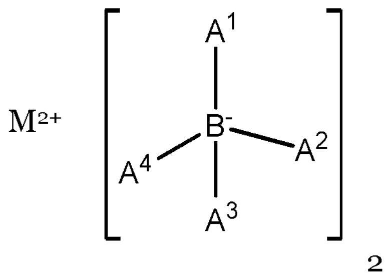

Formula (I)

wherein M may be the divalent metal ion, each of $A^1$- $A^4$ may be independently selected from H, substituted or unsubstituted $C_6$-$C_{20}$ aryl and substituted or unsubstituted $C_2$-$C_{20}$ heteroaryl. In this way, fine tuning of the electronic structure of the inventive constituents of the semiconducting material is achieved to improve the usability thereof in semiconducting layers of electronic devices, in particular in the electron transport layer thereof.

In the semiconducting material, at least one, alternatively at least two, alternatively at least three, alternatively four groups of $A^1$ to $A^4$ may be nitrogen-containing heteroaryl. In this way, fine tuning of the electronic structure of the inventive constituents of the semiconducting material is achieved to improve the usability thereof in semiconducting layers of electronic devices, in particular in the electron transport layer thereof.

In the semiconducting material, each nitrogen-containing heteroaryl may be bound to the central boron atom via a B-N bond. In this way, fine tuning of the electronic structure of the inventive constituents of the semiconducting material is achieved to improve the usability thereof in semiconducting layers of electronic devices, in particular in the electron transport layer thereof.

In the semiconducting material, the nitrogen-containing heteroaryl may be pyrazolyl. In this way, fine tuning of the electronic structure of the inventive constituents of the semiconducting material is achieved to improve the usability thereof in semiconducting layers of electronic devices, in particular in the electron transport layer thereof.

In the semiconducting material, the matrix compound may have the following formula (1).

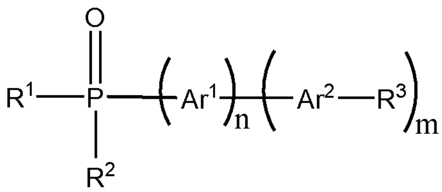

(1)

wherein $R^1$ and $R^2$ may be each independently selected from $C_1$ to $C_{16}$ alkyl; $Ar^1$ may be selected from $C_6$ to $C_{14}$ arylene or $C_3$ to $C_{12}$ heteroarylene; $Ar^2$ may be independently selected from $C_{14}$ to $C_{40}$ arylene or $C_8$ to $C_{40}$ heteroarylene; $R^3$ may be independently selected from H, $C_1$ to $C_{12}$ alkyl or $C_{10}$ to $C_{20}$ aryl; wherein each of $Ar^1$, $Ar^2$ and $R^3$ may be each independently unsubstituted or substituted with at least one $C_1$ to $C_{12}$ alky group; n may be 0 or 1; and m may be 1 in case of n = 0; and m may be 1 or 2 in case of n = 1. In this way, fine tuning of the electronic structure of the inventive constituents of the semiconducting material is achieved to improve the usability thereof in semiconducting layers of electronic devices, in particular in the electron transport layer thereof.

In the semiconducting material, $Ar^1$ may be selected from a group consisting of phenylene, biphenylene, naphthylene, fluorenylene, pyridylene, quinolinylene and pyrimidinylene. In this way, fine tuning of the electronic structure of the inventive constituents of the semiconducting material is achieved to improve the usability thereof in semiconducting layers of electronic devices, in particular in the electron transport layer thereof.

In the semiconducting material, $Ar^2$ may be selected from a group consisting of napthylene, fluorenylene, anthracenylene, pyrenylene, phenanthrylene, carbazoylene, benzo[c]acridinylene, dibenzo[c,h]acridinylene, dibenzo[a,j]acridinylene or from a group of the following formulas (IVa) to (IVm)

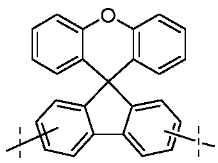 (IVa), 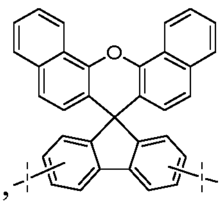 (IVb), 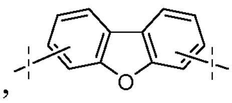 (IVc), 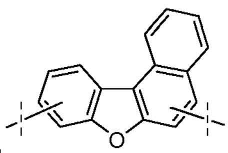 (IVd), 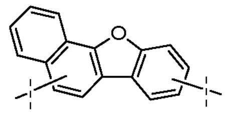 (IVe)

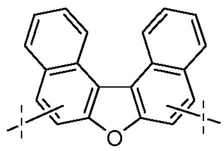 (IVf), 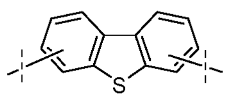 (IVg), 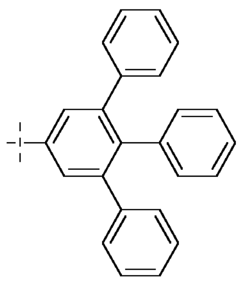 (IVh), 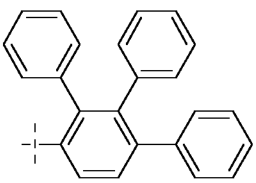 (IVi)

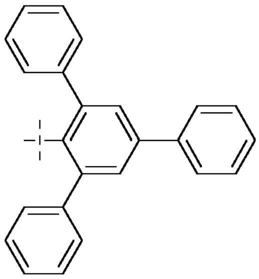

,

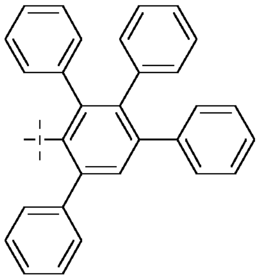

,

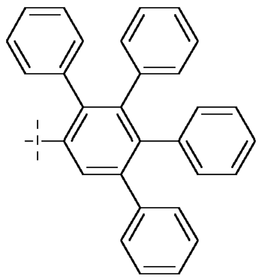

(IVj) (IVk) (IVl)

and

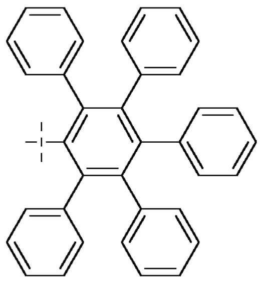

(IVm).

In this way, fine tuning of the electronic structure of the inventive constituents of the semiconducting material is achieved to improve the usability thereof in semiconducting layers of electronic devices, in particular in the electron transport layer thereof.

In the semiconducting material, $Ar^2$ may be selected from a group consisting of anthracenylene, pyrenylene, phenanthrylene, benzo[c]acridinylene, dibenzo[c,h]acridinylene and dibenzo[a,j]acridinylene. In this way, fine tuning of the electronic structure of the inventive constituents of the semiconducting material is achieved to improve the usability thereof in semiconducting layers of electronic devices, in particular in the electron transport layer thereof.

In the semiconducting material, $R^3$ may be selected from from H, phenyl, biphenyl, terphenyl, fluorenyl, naphthyl, phenanthryl, pyrenyl, carbazoyl, dibenzofuranyl or dinapthofuranyl. In this way, fine tuning of the electronic structure of the inventive constituents of the semiconducting material is achieved to improve the usability thereof in semiconducting layers of electronic devices, in particular in the electron transport layer thereof.

In the semiconducting material, the phosphine oxide compound may be selected from one of the following compounds a to g.

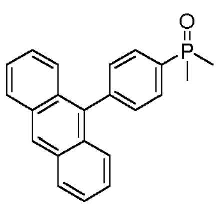

(a)

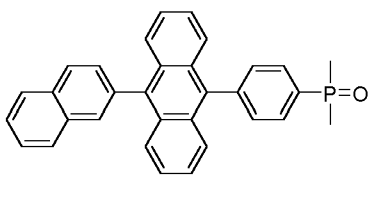

(b)

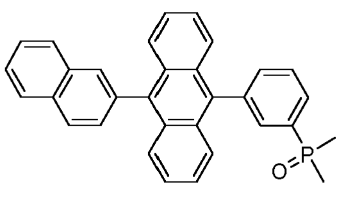

(c)

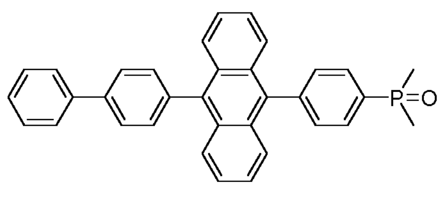

(d)

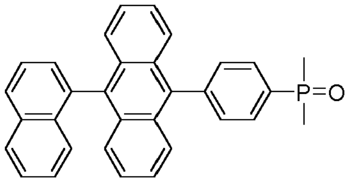 (e) 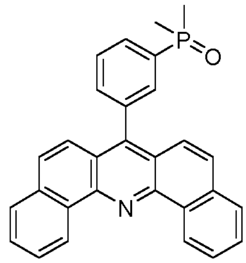 (f)

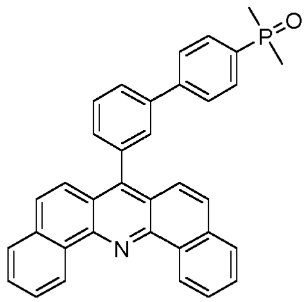 (g).

In this way, fine tuning of the electronic structure of the inventive constituents of the semiconducting material is achieved to improve the usability thereof in semiconducting layers of electronic devices, in particular in the electron transport layer thereof.

In the semiconducting material, the matrix compound may be an electron transport matrix compound. In this way, fine tuning of the electronic structure of the inventive constituents of the semiconducting material is achieved to improve the usability thereof in semiconducting layers of electronic devices, in particular in the electron transport layer thereof.

In the semiconducting material, the borate complex and the matrix compound may be present in the form of a homogenous mixture. In this way, fine tuning of the electronic structure of the inventive constituents of the semiconducting material is achieved to improve the usability thereof in semiconducting layers of electronic devices, in particular in the electron transport layer thereof.

The object is further achieved by an electronic device comprising a semiconducting layer made of the semiconducting material according to the invention.

The electronic device may be an organic electronic device.

The organic device may be an organic light emitting diode, and organic solar cell or an organic field effect transistor.

In the electronic device, the organic semiconducting layer may be an electron transport layer.

Finally, the object is achieved by a method for preparing the inventive semiconducting material, the method comprising the steps: (i) co-evaporating the divalent metal salt or divalent metal complex and the matrix material; and (ii) co-depositing the divalent metal salt or divalent metal complex and the matrix compound.

In the inventive method, the "substrate" may be any suitable adjacent layer. For example in case of the borate complex being comprised in an electron transport layer, the substrate may be an electron injection layer. Likewise, in case that the inventive borate complex is comprised in an electron injection layer, the substrate may be the electrode.

Further layers

In accordance with the invention, the organic electronic device may comprise, besides the layers already mentioned above, further layers. Exemplary embodiments of respective layers are described in the following:

*Substrate*

The substrate may be any substrate that is commonly used in manufacturing of, electronic devices, such as organic light-emitting diodes. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate or a silicon substrate.

*Anode electrode*

Either the first electrode or the second electrode may be an anode electrode. The anode electrode may be formed by depositing or sputtering a material that is used to form the anode electrode. The material used to form the anode electrode may be a high work-function material, so as to facilitate hole injection. The anode material may also be selected from a low work function material (i.e. aluminum). The anode electrode may be a transparent or reflective electrode. Transparent conductive oxides, such as indium tin oxide (ITO), indium zinc oxide (IZO), tin-dioxide ($SnO_2$), aluminum zinc oxide (AlZnO) and zinc oxide (ZnO), may be used to form the anode electrode. The anode electrode may also be formed using metals, typically silver (Ag), gold (Au), or metal alloys.

*Hole injection layer*

The hole injection layer (HIL) may be formed on the anode electrode by vacuum deposition, spin coating, printing, casting, slot-die coating, Langmuir-Blodgett (LB) deposition, or the like. When the HIL is formed using vacuum deposition, the deposition conditions may vary according to the compound that is used to form the HIL, and the desired structure and thermal properties of the HIL. In general, however, conditions for vacuum deposition may include a deposition temperature of 100° C to 500° C, a pressure of 10-8 to 10-3 Torr (1 Torr equals 133.322 Pa), and a deposition rate of 0.1 to 10 nm/sec.

When the HIL is formed using spin coating or printing, coating conditions may vary according to the compound that is used to form the HIL, and the desired structure and thermal properties of the HIL. For example, the coating conditions may include a coating speed of about 2000 rpm to about 5000 rpm, and a thermal treatment temperature of about 80° C to about 200° C. Thermal treatment removes a solvent after the coating is performed.

The HIL may be formed of any compound that is commonly used to form a HIL. Examples of compounds that may be used to form the HIL include a phthalocyanine compound, such as copper phthalocyanine (CuPc), 4,4',4"-tris (3-methylphenylphenylamino) triphenylamine (m-MTDATA), TDATA, 2T-NATA, polyaniline/dodecylbenzenesulfonic acid (Pani/DBSA), poly(3,4-ethylenedioxythiophene)/poly(4-styrenesulfonate) (PEDOT/PSS), polyaniline/camphor sulfonic acid (Pani/CSA), and polyaniline)/poly(4-styrenesulfonate (PANI/PSS).

The HIL may be a pure layer of p-type dopant and the p-type dopant may be selected from tetrafluoro-tetracyanoquinonedimethane (F4TCNQ), 2,2'-(perfluoronaphthalen-2,6-diylidene) dimalononitrile or 2,2',2"-(cyclopropane-1,2,3-triylidene)tris(2-(p-cyanotetrafluorophenyl)acetonitrile) but not limited hereto. The HIL may be selected from a hole-transporting matrix compound doped with a p-type dopant. Typical examples of known doped hole transport materials are: copper phthalocyanine (CuPc), which HOMO level is approximately -5.2 eV, doped with tetrafluoro-tetracyanoquinonedimethane (F4TCNQ), which LUMO level is about -5.2 eV; zinc phthalocyanine (ZnPc) (HOMO = -5.2 eV) doped with F4TCNQ; $\alpha$-NPD (N,N'-Bis(naphthalen-1-yl)-N,N'-bis(phenyl)-benzidine) doped with F4TCNQ. $\alpha$-NPD doped with 2,2'-(perfluoronaphthalen-2,6-diylidene) dimalononitrile. $\alpha$-NPD doped with 2,2',2"-(cyclopropane-1,2,3-triylidene)tris(2-(p-cyanotetrafluorophenyl)acetonitrile). Dopant concentrations can be selected from 1 to 20 wt.-%, more preferably from 3 wt.-% to 10 wt.-%.

The thickness of the HIL may be in the range from about 1 nm to about 100 nm, and for example, from about 1 nm to about 25 nm. When the thickness of the HIL is within this range, the HIL may have excellent hole injecting characteristics, without a substantial penalty in driving voltage.

*Hole transport layer*

The hole transport layer (HTL) may be formed on the HIL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL. However, the conditions for the vacuum or solution deposition may vary, according to the compound that is used to form the HTL.

The HTL may be formed of any compound that is commonly used to form a HTL. Compounds that can be suitably used are disclosed for example in Yasuhiko Shirota and Hiroshi Kageyama, Chem. Rev. 2007, 107, 953-1010. Examples of the compound that may be used to form the HTL are: carbazole derivatives, such as N-phenylcarbazole or polyvinylcarbazole; benzidine derivatives, such as N,N'-bis(3-methylphenyl)-N,N'-diphenyl-[1,1-biphenyl]-4,4'-diamine (TPD), or N,N'-di(naphthalen-1-yl)-N,N'-diphenyl benzidine (alpha-NPD); and triphenylamine-based compound, such as 4,4',4"-tris(N-carbazolyl)triphenylamine (TCTA). Among these compounds, TCTA can transport holes and inhibit excitons from being diffused into the EML.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 120 nm to about 140 nm. A preferred thickness of the HTL may be 170 nm to 200 nm. When the thickness of the HTL is within this range,

the HTL may have excellent hole transporting characteristics, without a substantial penalty in driving voltage.

*Electron blocking layer*

The function of the electron blocking layer (EBL) is to prevent electrons from being transferred from the emission layer to the hole transport layer and thereby confine electrons to the emission layer. Thereby, efficiency, operating voltage and/or lifetime are improved. Typically, the electron blocking layer comprises a triarylamine compound. The triarylamine compound may have a LUMO level closer to vacuum level than the LUMO level of the hole transport layer. The electron blocking layer may have a HOMO level that is further away from vacuum level compared to the HOMO level of the hole transport layer. The thickness of the electron blocking layer may be selected between 2 and 20 nm.

The electron blocking layer may comprise a compound of formula Z below (Z).

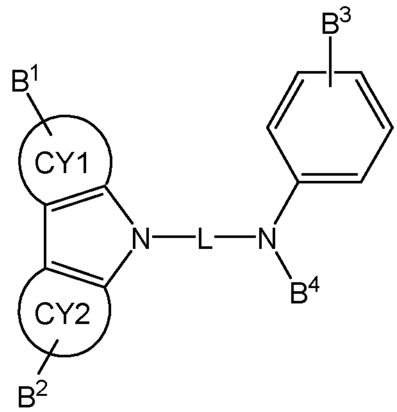

In Formula Z, CY1 and CY2 are the same as or different from each other, and each independently represent a benzene cycle or a naphthalene cycle, $B^1$ to $B^3$ are the same as or different from each other, and each independently selected from the group consisting of hydrogen; a substituted or unsubstituted aryl group having 6 to 30 carbon atoms; and a substituted or unsubstituted heteroaryl group having 5 to 30 carbon atoms, $B^4$ is selected from the group consisting of a substituted or unsubstituted phenyl group, a substituted or unsubstituted biphenyl group, a substituted or unsubstituted terphenyl group, a substituted or unsubstituted triphenylene group, and a substituted or unsubstituted heteroaryl group having 5 to 30 carbon atoms, L is a substituted or unsubstituted arylene group having 6 to 30 carbon atoms.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

*Emission layer (EML)*

The EML may be formed on the HTL by vacuum deposition, spin coating, slot-die coating, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.

The emission layer (EML) may be formed of a combination of a host and an emitter dopant. Example of the host are Alq3, 4,4'-N,N'-dicarbazole-biphenyl (CBP), poly(n-vinylcarbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPBI), 3-tert-butyl-9,10-di-2-naphthylanthracenee (TBADN), distyrylarylene (DSA), bis(2-(2-hydroxyphenyl)benzo-thiazolate)zinc (Zn(BTZ)2), G3 below, "AND", Compound 1 below, and Compound 2 below.

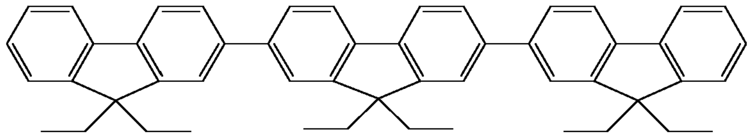

G3

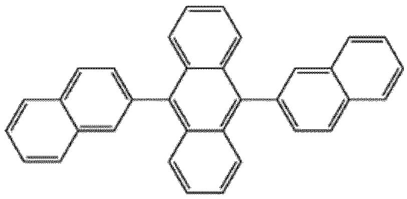

"AND"

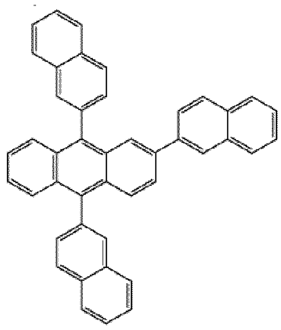

Compound 1

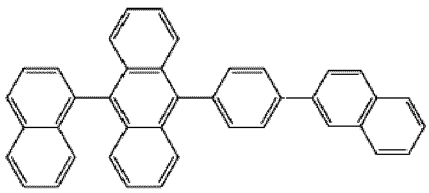

Compound 2

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, $Ir(piq)_3$, and Btp2Ir(acac), but are not limited thereto. These compounds are phosphorescent emitters, however, fluorescent red emitter dopants could also be used.

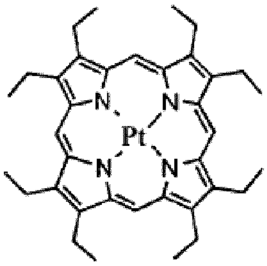

PtOEP

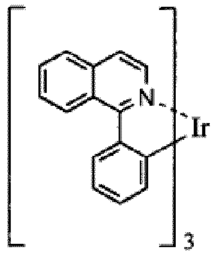

$Ir(piq)_3$

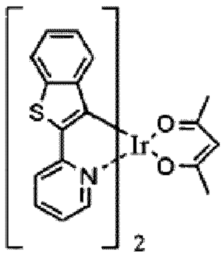

$Btp_2Ir(acac)$

Examples of phosphorescent green emitter dopants are $Ir(ppy)_3$ (ppy = phenylpyridine), Ir(ppy)2(acac), Ir(mpyp)3 are shown below. Compound 3 is an example of a fluorescent green emitter and the structure is shown below.

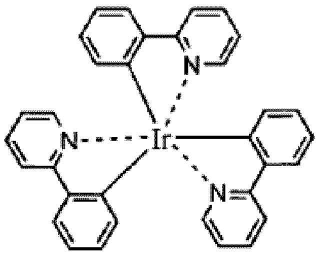

$Ir(ppy)_3$

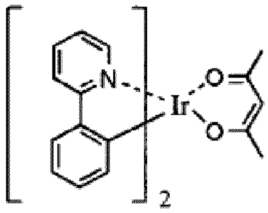

$Ir(ppy)_2(acac)$

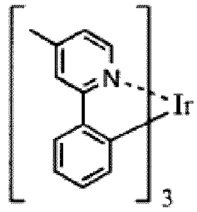

$Ir(mpyp)_3$

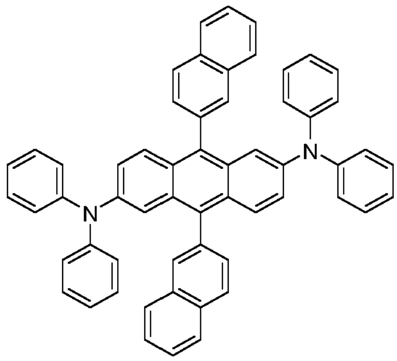

Compound 3

Examples of phosphorescent blue emitter dopants are F2Irpic, (F2ppy)2Ir(tmd) and $Ir(dfppz)_3$, ter-fluorene, the structures are shown below. 4.4'-bis(4-diphenyl amiostyryl)biphenyl (DPAVBi), 2,5,8,11-tetra-tert-butyl perylene (TBPe), and Compound 4 below are examples of fluorescent blue emitter dopants

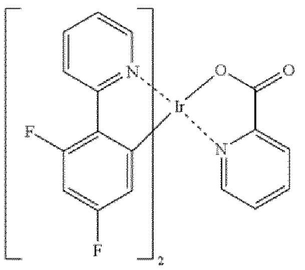

F2Irpic

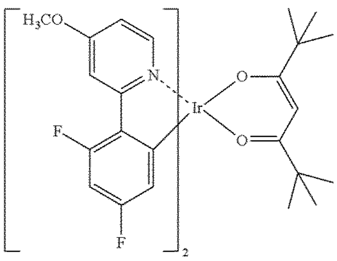

(F2ppy)2Ir(tmd)

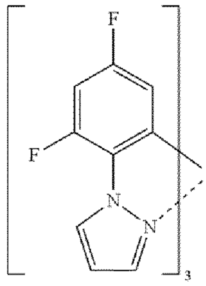

Ir(dfppz)3

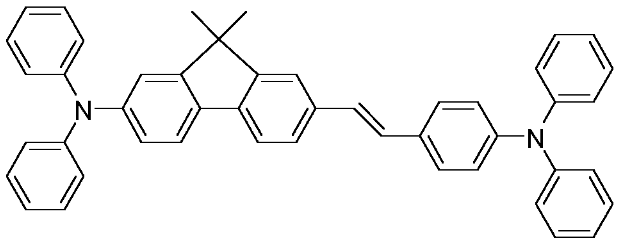

Compound 4

The amount of the emitter dopant may be in the range from about 0.01 to about 50 parts by weight, based on 100 parts by weight of the host. Alternatively, the emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

*Hole blocking layer (HBL)*

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include xadiazole derivatives, triazole derivatives, and phenanthroline derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

*Electron transport layer (ETL)*

The OLED according to the present invention may contain an electron transport layer (ETL). In accordance with the invention, the electron transport layer may be the inventive organic semiconducting layer comprising the inventive semiconducting material, i.e. the inventive combination of metal complex or metal salt and the dialkylphosphine oxid matrix compound as defined above.

According to various embodiments the OLED may comprise an electron transport layer or an electron transport layer stack comprising at least a first electron transport layer and at least a second electron transport layer.

By suitably adjusting energy levels of particular layers of the ETL, the injection and transport of the electrons may be controlled, and the holes may be efficiently blocked. Thus, the OLED may have long lifetime.

The electron transport layer of the organic electronic device may comprise the semiconducting material as defined above as the organic electron transport matrix (ETM) material. The electron transport layer may comprise, besides the combination of metal complex or metal salt and the dialkylphosphine oxid matrix compound, further ETM materials known in the art. Likewise, the electron transport layer may comprise as the only electron transport matrix material the combination of metal complex or metal salt and the dialkylphosphine oxid matrix compound. In case that

the inventive organic electronic device comprises more than one electron transport layers, the combination of metal complex or metal salt and the dialkylphosphine oxid matrix compound may be comprised in only one of the electron transport layers, in more than one of the electron transport layers or in all of the electron transport layers. In accordance with the invention, the electron transport layer may comprise, besides the ETM material, at least one additive as defined below. Further, the electron transport layer may comprise one or more n-type dopants. The additive may be an n-type dopant. The additive can be alkali metal, alkali metal compound, alkaline earth metal, alkaline earth metal compound, transition metal, transition metal compound or a rare earth metal. In another embodiment, the metal can be one selected from a group consisting of Li, Na, K, Rb, Cs, Mg, Ca, Sr, Ba, La, Ce, Sm, Eu, Tb, Dy, and Yb. In another emdodiment, the n-type dopant can be one selected from a group consisting of Cs, K, Rb, Mg, Na, Ca, Sr, Eu and Yb. In an embodiment the alkali metal compound may be 8-Hydroxyquinolinolato-lithium (LiQ), Lithium tetra(1H-pyrazol-1-yl)borate or Lithium 2-(diphenylphosphoryl)phenolate. Suitable compounds for the ETM (which may be used in addition to the inventive compound represented by the general formula (I) as defined above) are not particularly limited. In one embodiment, the electron transport matrix compounds consist of covalently bound atoms. Preferably, the electron transport matrix compound comprises a conjugated system of at least 6, more preferably of at least 10 delocalized electrons. In one embodiment, the conjugated system of delocalized electrons may be comprised in aromatic or heteroaromatic structural moieties, as disclosed e.g. in documents EP 1970 371 A1 or WO 2013/079217 A1.

*Electron injection layer (EIL)*

The optional EIL, which may facilitates injection of electrons from the cathode, may be formed on the ETL, preferably directly on the electron transport layer. In accordance with the invention, the EIL may be the semiconducting layer comprising the combination of metal complex or metal salt and the dialkylphosphine oxid matrix compound. If the combination of metal complex or metal salt and the dialkylphosphine oxid matrix compound is not comprised in the EIL but in another layer, for example the ETL, the EIL material may be selected from materials known in the art for a respective use. Examples of materials for forming the EIL include lithium 8-hydroxyquinolinolate (LiQ), LiF, NaCl, CsF, Li2O, BaO, Ca, Ba, Yb, Mg which are known in the art. Deposition and coating conditions for forming the EIL are similar to those for formation of the HIL, although the deposition and coating conditions may vary, according to the material that is used to form the EIL.

The thickness of the EIL may be in the range from about 0.1 nm to about 10 nm, for example, in the range from about 0.5 nm to about 9 nm. When the thickness of the EIL is within this range, the EIL may have satisfactory electron-injecting properties, without a substantial penalty in driving voltage.

*Cathode electrode*

The cathode electrode is formed on the EIL if present. The cathode electrode may be formed of a metal, an alloy, an electrically conductive compound, or a mixture thereof. The cathode electrode may have a low work function. For example, the cathode electrode may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode electrode may be formed of a transparent conductive oxides, such as ITO or IZO.

The thickness of the cathode electrode may be in the range from about 5 nm to about 1000 nm, for example, in the range from about 10 nm to about 100 nm. When the thickness of the cathode electrode is in the range from about 5 nm to about 50 nm, the cathode electrode may be transparent or semitransparent even if formed from a metal or metal alloy.

It is to be understood that the cathode electrode is not part of an electron injection layer or the electron transport layer.

*Charge generation layer/hole generating layer*

The charge generation layer (CGL) may be composed of a double layer.

Typically, the charge generation layer is a pn junction joining a n-type charge generation layer (electron generating layer) and a hole generating layer. The n-side of the pn junction generates electrons and injects them into the layer which is adjacent in the direction to the anode. Analogously, the p-side of the p-n junction generates holes and injects them into the layer which is adjacent in the direction to the cathode.

Charge generating layers are used in tandem devices, for example, in tandem OLEDs comprising, between two electrodes, two or more emission layers. In a tandem OLED comprising two emission layers, the n-type charge generation layer provides electrons for the first light emission layer arranged near the anode, while the hole generating layer provides holes to the second light emission layer arranged between the first emission layer and the cathode.

Suitable matrix materials for the hole generating layer may be materials conventionally used as hole injection

and/or hole transport matrix materials. Also, p-type dopant used for the hole generating layer can employ conventional materials. For example, the p-type dopant can be one selected from a group consisting of tetrafluore-7,7,8,8-tetracyanoquinodimethane (F4-TCNQ), derivatives of tetracyanoquinodimethane, radialene derivatives, iodine, FeCl3, FeF3, and SbCl5. Also, the host can be one selected from a group consisting of N,N'-di(naphthalen-1-yl)-N,N-diphenyl-benzidine (NPB), N,N'-diphenyl-N,N'-bis(3-methylphenyl)-1,1-biphenyl-4,4'-diamine (TPD) and N,N',N'-tetranaphthyl-benzidine (TNB).

The n-type charge generation layer can be layer of a neat n-type dopant, for example of an electropositive metal, or can consist of an organic matrix material doped with the n-type dopant. In accordance with the invention, the n-type charge generation layer (= electron generating layer) may be the layer comprising the combination of metal complex or metal salt and the dialkylphosphine oxid matrix compound. In cases where the combination of metal complex or metal salt and the dialkylphosphine oxid matrix compound is not comprised in the electron generating layer, but in another layer, for example the electron transport layer or the electron injection layer, the material of the n-type charge generation layer may be selected from materials well-known in the art for this purpose. In one embodiment, the n-type dopant can be alkali metal, alkali metal compound, alkaline earth metal, alkaline earth metal compound, a transition metal, a transition metal compound or a rare earth metal. In another embodiment, the metal can be one selected from a group consisting of Li, Na, K, Rb, Cs, Mg, Ca, Sr, Ba, La, Ce, Sm, Eu, Tb, Dy, and Yb. More specifically, the n-type dopant can be one selected from a group consisting of Cs, K, Rb, Mg, Na, Ca, Sr, Eu and Yb. Suitable matrix materials for the electron generating layer may be the materials conventionally used as matrix materials for electron injection or electron transport layers. The matrix material can be for example one selected from a group consisting of triazine compounds, hydroxyquinoline derivatives like tris(8-hydroxyquinoline)aluminum, benzazole derivatives, and silole derivatives.

In one embodiment, the n-type charge generation layer may include compounds of the following Chemical Formula X.

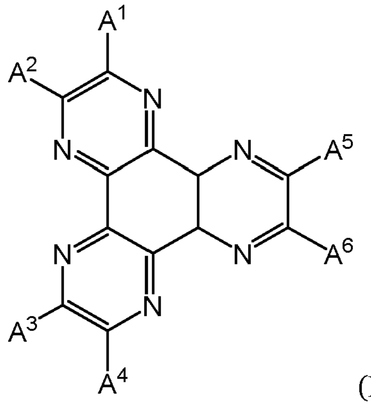

, (X),

wherein each of $A^1$ to $A^6$ may be hydrogen, a halogen atom, nitrile (-CN), nitro (-NO2), sulfonyl (-SO2R), sulfoxide (-SOR), sulfonamide (-SO2NR), sulfonate (-SO3R), trifluoromethyl (-CF3), ester (-COOR), amide (-CONHR or -CONRR'), substituted or unsubstituted straight-chain or branched-chain C1-C12 alkoxy, substituted or unsubstituted straight-chain or branched-chain C1-C12 alkyl, substituted or unsubstituted straight-chain or branched chain C2-C12 alkenyl, a substituted or unsubstituted aromatic or non-aromatic heteroring, substituted or unsubstituted aryl, substituted or unsubstituted mono- or di-arylamine, substituted or unsubstituted aralkylamine, or the like. Herein, each of the above R and R' may be substituted or unsubstituted C1-C60 alkyl, substituted or unsubstituted aryl, or a substituted or unsubstituted 5- to 7-membered heteroring, or the like.

An example of such n-type charge generation layer may be a layer comprising CNHAT

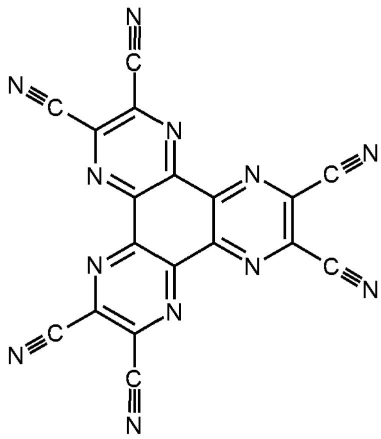

(CNHAT).

The hole generating layer is arranged on top of the n-type charge generation layer.

*Organic light-emitting diode (OLED)*

The organic electronic device according to the invention may be an organic light-emitting device.

According to one aspect of the present invention, there is provided an organic light-emitting diode (OLED) comprising: a substrate; an anode electrode formed on the substrate; a hole injection layer, a hole transport layer, an emission layer, and a cathode electrode.

According to another aspect of the present invention, there is provided an OLED comprising: a substrate; an anode electrode formed on the substrate; a hole injection layer, a hole transport layer, an electron blocking layer, an emission layer, a hole blocking layer and a cathode electrode.

According to another aspect of the present invention, there is provided an OLED comprising: a substrate; an anode electrode formed on the substrate; a hole injection layer, a hole transport layer, an electron blocking layer, an emission layer, a hole blocking layer, an electron transport layer, and a cathode electrode.

According to another aspect of the present invention, there is provided an OLED comprising: a substrate; an anode electrode formed on the substrate; a hole injection layer, a hole transport layer, an electron blocking layer, an emission layer, a hole blocking layer, an electron transport layer, an electron injection layer, and a cathode electrode.

According to various embodiments of the present invention, there may be provided OLEDs layers arranged between the above mentioned layers, on the substrate or on the top electrode.

According to one aspect, the OLED can comprise a layer structure of a substrate that is adjacent arranged to an anode electrode, the anode electrode is adjacent arranged to a first hole injection layer, the first hole injection layer is adjacent arranged to a first hole transport layer, the first hole transport layer is adjacent arranged to a first electron blocking layer, the first electron blocking layer is adjacent arranged to a first emission layer, the first emission layer is adjacent arranged to a first electron transport layer, the first electron transport layer is adjacent arranged to an n-type charge generation layer, the n-type charge generation layer is adjacent arranged to a hole generating layer, the hole generating layer is adjacent arranged to a second hole transport layer, the second hole transport layer is adjacent arranged to a second electron blocking layer, the second electron blocking layer is adjacent arranged to a second emission layer, between the second emission layer and the cathode electrode an optional electron transport layer and/or an optional injection layer are arranged.

For example, the OLED according to Fig. 2 may be formed by a process, wherein on a substrate (110), an anode (120), a hole injection layer (130), a hole transport layer (140), an electron blocking layer (145), an emission layer (150), a hole blocking layer (155), an electron transport layer (160), an electron injection layer (180) and the cathode electrode (190) are subsequently formed in that order.

Organic electronic device

An organic electronic device according to the invention comprises an organic semiconducting layer comprising a compound according to formula I.

An organic electronic device according to one embodiment may include a substrate, an anode layer, an organic semiconducting layer comprising a compound of formula 1 and a cathode layer.

An organic electronic device according to one embodiment comprises at least one organic semiconducting layer comprising at least one compound of formula I, at least one anode layer, at least one cathode layer and at least

one emission layer, wherein the organic semiconducting layer is preferably arranged between the emission layer and the cathode layer.

An organic light-emitting diode (OLED) according to the invention may include an anode, a hole transport layer (HTL), an emission layer (EML), an electron transport layer (ETL) comprising at least one compound of formula 1, and a cathode, which are sequentially stacked on a substrate. In this regard, the HTL, the EML, and the ETL are thin films formed from organic compounds.

An organic electronic device according to one embodiment can be a light emitting device, thin film transistor, a battery, a display device or a photovoltaic cell, and preferably a light emitting device.

According to another aspect of the present invention, there is provided a method of manufacturing an organic electronic device, the method using:

- at least one deposition source, preferably two deposition sources and more preferred at least three deposition sources.

The methods for deposition that can be suitable comprise:

- deposition via vacuum thermal evaporation;
- deposition via solution processing, preferably the processing is selected from spin-coating, printing, casting; and/or
- slot-die coating.

According to various embodiments of the present invention, there is provided a method using:

- a first deposition source to release the compound of formula 1 according to the invention, and
- a second deposition source to release the alkali halide or alkali organic complex, preferably a lithium halide or lithium organic complex;

the method comprising the steps of forming the electron transport layer stack; whereby for an organic light-emitting diode (OLED):

the first electron transport layer is formed by releasing the compound of formula 1 according to the invention from the first deposition source and an alkali metal compound, preferably an alkali halide or alkali organic complex, preferably a lithium halide or lithium organic complex from the second deposition source.

According to various embodiments of the present invention, the method may further include forming on the anode electrode an emission layer and at least one layer selected from the group consisting of forming a hole injection layer, forming a hole transport layer, or forming a hole blocking layer, between the anode electrode and the first electron transport layer.

According to various embodiments of the present invention, the method may further include the steps for forming an organic light-emitting diode (OLED), wherein

- on a substrate a first anode electrode is formed,
- on the first anode electrode an emission layer is formed,
- on the emission layer an electron transport layer stack is formed, preferably a first electron transport layer is formed on the emission layer and optional a second electron transport layer is formed,
- and finally a cathode electrode is formed,
- optional a hole injection layer, a hole transport layer, and a hole blocking layer, formed in that order between the first anode electrode and the emission layer,
- optional an electron injection layer is formed between the electron transport layer and the cathode electrode.

According to various embodiments of the present invention, the method may further include forming an electron injection layer on a first electron transport layer. However, according to various embodiments of the OLED of the present invention, the OLED may not comprise an electron injection layer.

According to various embodiments, the OLED may have the following layer structure, wherein the layers having the following order:
anode, hole injection layer, first hole transport layer, second hole transport layer, emission layer, optional second electron transport layer, first electron transport layer comprising a compound of formula 1 according to the invention, optional electron injection layer, and cathode.

According to another aspect of the invention, it is provided an electronic device comprising at least one organic light emitting device according to any embodiment described throughout this application, preferably, the electronic device comprises the organic light emitting diode in one of embodiments described throughout this application. More preferably, the electronic device is a display device.

In one embodiment, the organic electronic device according to the invention comprising an organic semiconducting layer can further comprise a layer comprising a radialene compound and/or a quinodimethane compound.

In one embodiment, the radialene compound and/or the quinodimethane compound may be substituted with one or more halogen atoms and/or with one or more electron withdrawing groups. Electron withdrawing groups can be selected from nitrile groups, halogenated alkyl groups, alternatively from perhalogenated alkyl groups, alternatively from perfluorinated alkyl groups. Other examples of electron withdrawing groups may be acyl, sulfonyl groups or phosphoryl groups.

Alternatively, acyl groups, sulfonyl groups and/or phosphoryl groups may comprise halogenated and/or perhalogenated hydrocarbyl. In one embodiment, the perhalogenated hydrocarbyl may be a perfluorinated hydrocarbyl. Examples of a perfluorinated hydrocarbyl can be perfluormethyl, perfluorethyl, perfluorpropyl, perfluorisopropyl, perfluorobutyl, perfluorophenyl, perfluorotolyl; examples of sulfonyl groups comprising a halogenated hydrocarbyl may be trifluoromethylsulfonyl, pentafluoroethylsulfonyl, pentafluorophenylsulfonyl, heptafluoropropylsufonyl, nonafluorobutylsulfonyl, and like.

In one embodiment, the radialene and/or the quinodimethane compound may be comprised in a hole injection, hole transporting and/or a hole generation layer.

In one embodiment, the radialene compound may have formula (XX) and/or the quinodimethane compound may have formula (XXIa) or (XXIb):

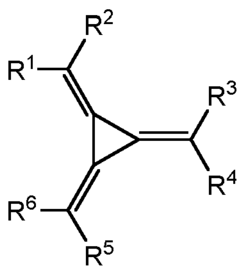

(XX)

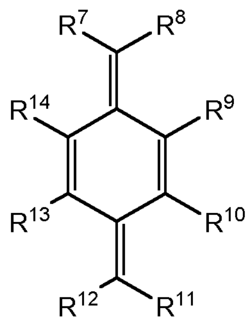

(XXIa)

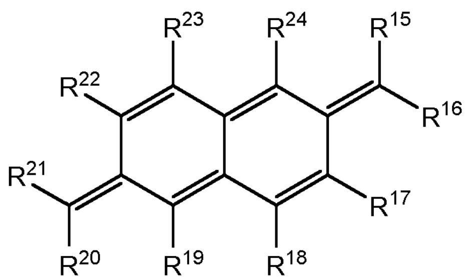

(XXIb),

wherein $R^1$, $R^2$, $R^3$, $R^4$, $R^5$, $R^6$, $R^7$, $R^8$, $R^{11}$, $R^{12}$, $R^{15}$, $R^{16}$, $R^{20}$, $R^{21}$ are independently selected from above mentioned electron withdrawing groups and $R^9$, $R^{10}$, $R^{13}$, $R^{14}$, $R^{17}$, $R^{18}$, $R^{19}$, $R^{22}$, $R^{23}$ and $R^{24}$ are independently selected from H, halogen and above mentioned electron withdrawing groups.

Hereinafter, the embodiments are illustrated in more detail with reference to examples. However, the present disclosure is not limited to the following examples. Reference will now be made in detail to the exemplary aspects.

Details and definitions of the invention

The term "borate" refers to inorganic or organo-boron anions. In one embodiment, the borate may consist of a central boron atom and four organic groups, i.e. may have the general formula $BR_4$. In one embodiment, at least one of the groups R may be a heterocyclic group. The borate ligand (= borate anion) is negatively charged. The negative charge is balanced by the divalent counter-cation.

In the present specification, when a definition is not otherwise provided, an "alkyl group" may refer to an aliphatic hydrocarbon group. The alkyl group may refer to "a saturated alkyl group" without any double bond or triple bond. The term "alkyl" as used herein shall encompass linear as well as branched and cyclic alkyl. For example, $C_3$-alkyl may be selected from n-propyl and iso-propyl. Likewise, $C_4$-alkyl encompasses n-butyl, sec-butyl and t-butyl. Likewise, $C_6$-alkyl encompasses n-hexyl and cyclo-hexyl.

The subscribed number n in $C_n$ relates to the total number of carbon atoms in the respective alkyl, arylene, heteroarylene or aryl group.

The term "aryl" or "arylene" as used herein shall encompass phenyl ($C_6$-aryl), fused aromatics, such as naphthalene, anthracene, phenanthracene, tetracene etc. Further encompassed are biphenyl and oligo- or polyphenyls, such as terphenyl etc. Further encompassed shall be any further aromatic hydrocarbon substituents, such as fluorenyl etc. Arylene, respectively heteroarylene refers to groups to which two further moieties are attached. In the present specification "arylene group" may refer to a group comprising at least one hydrocarbon aromatic moiety, and all the elements of the hydrocarbon aromatic moiety may have p-orbitals which form conjugation, for example a phenyl group, a naphtyl group, an anthracenyl group, a phenanthrenyl group, a pyrenyl group, a fluorenyl group and the like. The arylene group may include a monocyclic, polycyclic or fused ring polycyclic (i.e., rings sharing adjacent pairs of carbon atoms) functional group.

The term "heteroaryl" or "hereroarylene" as used herein refers to aryl groups in which at least one carbon atom is substituted by a heteroatom, preferably selected from N, O, S, B or Si.

The subscripted number n in $C_n$-heteroaryl merely refers to the number of carbon atoms excluding the number of heteroatoms. In this context, it is clear that a $C_3$ heteroarylene group is an aromatic compound comprising three carbon atoms, such as pyrazol, imidazole, oxazole, thiazole and the like.

The term "heteroaryl" may refer to aromatic heterocycles with at least one heteroatom, and all the elements of the hydrocarbon heteroaromatic moiety may have p-orbitals which form conjugation. The heteroatom may be selected from N, O, S, B, Si, P, Se, preferably from N, O and S. A heteroarylene ring may comprise at least 1 to 3 heteroatoms. Preferably a heteroarylene ring may comprise at least 1 to 3 heteroatoms individually selected from N, S and/or O.

The term "heteroarylene" as used herewith shall encompass pyridine, quinoline, quinazoline, pyridine, triazine, benzimidazole, benzothiazole, benzo[4,5]thieno[3,2-d]pyrimidine, carbazole, xanthene, phenoxazine, benzoacridine, dibenzoacridine and the like.

In the present specification, the single bond refers to a direct bond.

In terms of the invention, the expression "between" with respect to one layer being between two other layers does not exclude the presence of further layers which may be arranged between the one layer and one of the two other layers. In terms of the invention, the expression "in direct contact" with respect to two layers being in direct contact with each other means that no further layer is arranged between those two layers. One layer deposited on the top of another layer is deemed to be in direct contact with this layer.

With respect to the inventive organic semiconductive layer as well as with respect to the inventive compound, the compounds mentioned in the experimental part are most preferred.

The inventive organic electronic device may be an organic electroluminescent device (OLED) an organic photovoltaic device (OPV), a lighting device, or an organic field-effect transistor (OFET).A lighting device may be any of the devices used for illumination, irradiation, signaling, or projection. They are correspondingly classified as illuminating, irradiating, signaling, and projecting devices. A lighting device usually consists of a source of optical radiation, a device that transmits the radiant flux into space in the desired direction, and a housing that joins the parts into a single device and protects the radiation source and light-transmitting system against damage and the effects of the surroundings.

According to another aspect, the organic electroluminescent device according to the present invention may comprise more than one emission layer, preferably two or three emission layers. An OLED comprising more than one emission layer is also described as a tandem OLED or stacked OLED.

The organic electroluminescent device (OLED) may be a bottom- or top-emission device.

Another aspect is directed to a device comprising at least one organic electroluminescent device (OLED). A device comprising organic light-emitting diodes is for example a display or a lighting panel.

In the present invention, the following defined terms, these definitions shall be applied, unless a different definition is given in the claims or elsewhere in this specification.

In the context of the present specification the term "different" or "differs" in connection with the matrix material means that the matrix material differs in their structural formula.

The energy levels of the highest occupied molecular orbital, also named HOMO, and of the lowest unoccupied molecular orbital, also named LUMO, are measured in electron volt (eV) indirectly by cyclic voltammetry vs ferrocene or can be calculated using simulation B3LYP with a 6-31G* basis set.

The terms "OLED" and "organic light-emitting diode" are simultaneously used and have the same meaning. The term "organic electroluminescent device" as used herein may comprise both organic light emitting diodes as well as organic light emitting transistors (OLETs).

As used herein, "weight percent", "wt.-%", "percent by weight", "% by weight", and variations thereof refer to a composition, component, substance or agent as the weight of that component, substance or agent of the respective electron transport layer divided by the total weight of the respective electron transport layer thereof and multiplied by 100. It is under-stood that the total weight percent amount of all components, substances and agents of the respective electron transport layer and electron injection layer are selected such that it does not exceed 100 wt.-%.

As used herein, "volume percent", "vol.-%", "percent by volume", "% by volume", and variations thereof refer to a composition, component, substance or agent as the volume of that component, substance or agent of the respective electron transport layer divided by the total volume of the respective electron transport layer thereof and multiplied by 100. It is understood that the total volume percent amount of all components, substances and agents of the cathode layer are selected such that it does not exceed 100 vol.-%.

All numeric values are herein assumed to be modified by the term "about", whether or not explicitly indicated. As used herein, the term "about" refers to variation in the numerical quantity that can occur. Whether or not modified by the term "about" the claims include equivalents to the quantities.

It should be noted that, as used in this specification and the appended claims, the singular forms "a", "an", and "the" include plural referents unless the content clearly dictates otherwise.

The term "free of', "does not contain", "does not comprise" does not exclude impurities. Impurities have no technical effect with respect to the object achieved by the present invention.

In the context of the present specification the term "essentially non-emissive" or "non-emitting" means that the contribution of the compound or layer to the visible emission spectrum from the device is less than 10 %, preferably less than 5 % relative to the visible emission spectrum. The visible emission spectrum is an emission spectrum with a wavelength of about ≥ 380 nm to about ≤ 780 nm.

Preferably, the organic semiconducting layer comprising the compound of formula I is essentially non-emissive or non-emitting.

The operating voltage, also named U, is measured in Volt (V) at 10 milliAmpere per square centimeter (mA/cm2).

The candela per Ampere efficiency, also named cd/A efficiency is measured in candela per ampere at 10 milliAmpere per square centimeter (mA/cm2).

The external quantum efficiency, also named EQE, is measured in percent (%).

The color space is described by coordinates CIE-x and CIE-y (International Commission on Illumination 1931). For blue emission the CIE-y is of particular importance. A smaller CIE-y denotes a deeper blue color.

The highest occupied molecular orbital, also named HOMO, and lowest unoccupied molecular orbital, also named LUMO, are measured in electron volt (eV).

The term "OLED", "organic light emitting diode", "organic light emitting device", "organic optoelectronic device" and "organic light-emitting diode" are simultaneously used and have the same meaning.

The term "transition metal" means and comprises any element in the d-block of the periodic table, which comprises groups 3 to 12 elements on the periodic table.

The term "group III to VI metal" means and comprises any metal in groups III to VI of the periodic table.

The term "life-span" and "lifetime" are simultaneously used and have the same meaning.

All numeric values are herein assumed to be modified by the term "about", whether or not explicitly indicated. As used herein, the term "about" refers to variation in the numerical quantity that can occur.

Whether or not modified by the term "about", the claims include equivalents to the quantities.

It should be noted that, as used in this specification and the appended claims, the singular forms "a", "an", and "the" include plural referents unless the content clearly dictates otherwise.

The anode electrode and cathode electrode may be described as anode electrode / cathode electrode or anode electrode / cathode electrode or anode electrode layer / cathode electrode layer.

The dipole moment $|\vec{\mu}|$ of a molecule containing N atoms is given by:

$$\vec{\mu} = \sum_{i}^{N} q_i \vec{r_i}$$

$$|\vec{\mu}| = \sqrt{\mu_x^2 + \mu_y^2 + \mu_z^2}$$

where $q_i$ and $\vec{r_i}$ are the partial charge and position of atom in the molecule.

The dipole moment is determined by a semi-empirical molecular orbital method.

The partial charges and atomic positions in the gas phase are obtained using the hybrid functional B3LYP with a 6-31G* basis set as implemented in the program package TURBOMOLE V6.5. If more than one conformation is viable, the conformation with the lowest total energy is selected to determine the dipole moment.

The reduction potential may be determined by cyclic voltammetry with potentiostatic device Metrohm PGSTAT30 and software Metrohm Autolab GPES at room temperature. The redox potentials are measured in an argon de-aerated, anhydrous 0.1M THF solution of the compound of formula I, under argon atmosphere, with 0.1M tetrabutylammonium hexafluorophosphate as supporting electrolyte, between platinum working electrodes and with an Ag/AgCl pseudo-standard electrode (Metrohm Silver rod electrode), consisting of a silver wire covered by silver chloride and immersed directly in the measured solution, with the scan rate 100 mV/s. The first run is done in the broadest range of the potential set on the working electrodes, and the range is then adjusted within subsequent runs appropriately. The final three runs are done with the addition of ferrocene (in 0.1M concentration) as the standard. The average of potentials corresponding to cathodic and anodic peak of the compound is determined through subtraction of the average of cathodic and anodic potentials observed for the standard $Fc^+$/Fc redox couple.

Room temperature, also named ambient temperature, is 23°C.

BRIEF DESCRIPTION OF THE DRAWINGS

These and/or other aspects and advantages of the present invention will become apparent and more readily appreciated from the following description of the exemplary embodiments, taken in conjunction with the accompanying drawings, of which:

FIG. 1 is a schematic sectional view of an organic light-emitting diode (OLED), according to an exemplary embodiment of the present invention;

FIG. 2 is a schematic sectional view of an OLED, according to an exemplary embodiment of the present invention.

FIG. 3 is a schematic sectional view of a tandem OLED comprising a charge generation layer, according to an exemplary embodiment of the present invention.

DETAILED DESCRIPTION

Reference will now be made in detail to the exemplary embodiments of the present invention, examples of which are illustrated in the accompanying drawings, wherein like reference numerals refer to the like elements throughout. The exemplary embodiments are described below, in order to explain the aspects of the present invention, by referring to the figures.

Herein, when a first element is referred to as being formed or disposed "on" or "onto" a second element, the first element can be disposed directly on the second element, or one or more other elements may be disposed there between. When a first element is referred to as being formed or disposed "directly on" or "directly onto" a second element, no other elements are disposed there between.

FIG. 1 is a schematic sectional view of an organic light-emitting diode (OLED) 100, according to an exemplary embodiment of the present invention. The OLED 100 includes a substrate 110, an anode 120, a hole injection layer (HIL) 130, a hole transport layer (HTL) 140, an emission layer (EML) 150, an electron transport layer (ETL) 160. The electron transport layer (ETL) 160 is formed on the EML 150. Onto the electron transport layer (ETL) 160, an electron injection layer (EIL) 180 is disposed. The cathode 190 is disposed directly onto the electron injection layer (EIL) 180.

Instead of a single electron transport layer 160, optionally an electron transport layer stack (ETL) can be used.

Fig. 2 is a schematic sectional view of an OLED 100, according to another exemplary embodiment of the present invention. Fig. 2 differs from Fig. 1 in that the OLED 100 of Fig. 2 comprises an electron blocking layer (EBL) 145 and a hole blocking layer (HBL) 155.

Referring to Fig. 2, the OLED 100 includes a substrate 110, an anode 120, a hole injection layer (HIL) 130, a hole transport layer (HTL) 140, an electron blocking layer (EBL) 145, an emission layer (EML) 150, a hole blocking layer (HBL) 155, an electron transport layer (ETL) 160, an electron injection layer (EIL) 180 and a cathode electrode 190.

Fig. 3 is a schematic sectional view of a tandem OLED 200, according to another exemplary embodiment of the present invention. Fig. 3 differs from Fig. 2 in that the OLED 100 of Fig. 3 further comprises a charge generation layer (CGL) and a second emission layer (151).

Referring to Fig. 3, the OLED 200 includes a substrate 110, an anode 120, a first hole injection layer (HIL) 130, a first hole transport layer (HTL) 140, a first electron blocking layer (EBL) 145, a first emission layer (EML) 150, a first hole blocking layer (HBL) 155, a first electron transport layer (ETL) 160, an n-type charge generation layer (n-type CGL) 185, a hole generating layer (p-type charge generation layer; p-type GCL) 135, a second hole transport layer (HTL) 141, a second electron blocking layer (EBL) 146, a second emission layer (EML) 151, a second hole blocking layer (EBL) 156, a second electron transport layer (ETL) 161, a second electron injection layer (EIL) 181 and a cathode 190.

While not shown in Fig. 1, Fig. 2 and Fig. 3, a sealing layer may further be formed on the cathode electrodes 190, in order to seal the OLEDs 100 and 200. In addition, various other modifications may be applied thereto.

Hereinafter, one or more exemplary embodiments of the present invention will be described in detail with, reference to the following examples. However, these examples are not intended to limit the purpose and scope of the one or more exemplary embodiments of the present invention.

EXPERIMENTAL PART

Using following model blue OLED device, performance of the inventive materials comprising divalent metal n-dopants / electron injection materials E1, E2 and B1 was compared with the closest state-of-art materials comprising as a n-dopant monovalent metal salt C1.

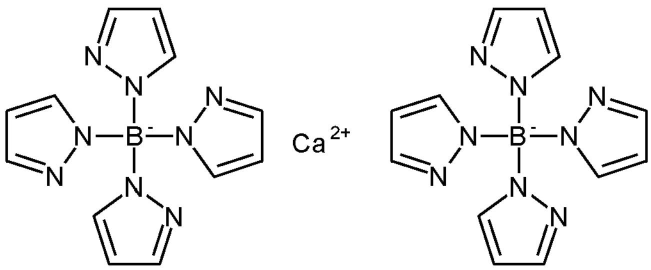

compound E1, CAS 12149-62-1,

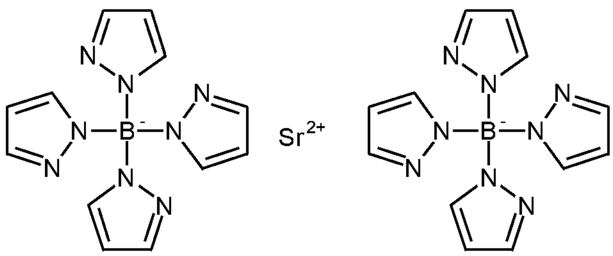

compound E2, CAS 12149-65-4,

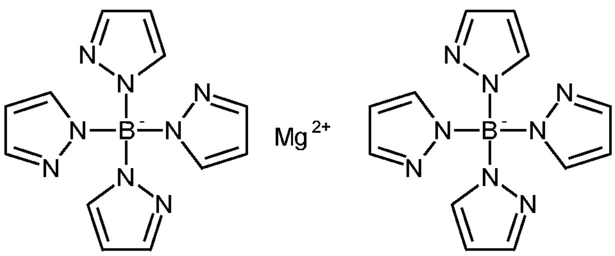

compound Bi, CAS 14784-09-9.

The closest state-of-art ETL materials comprised as a n-dopant lithium tetrakis(1H-pyrazol-i-yl)borate,

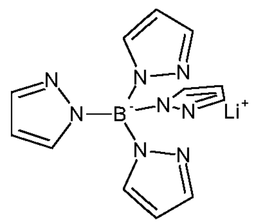

C1, CAS 14728-62-2.

The formulae of the supporting materials mentioned in tables below are as follows:

F1 is

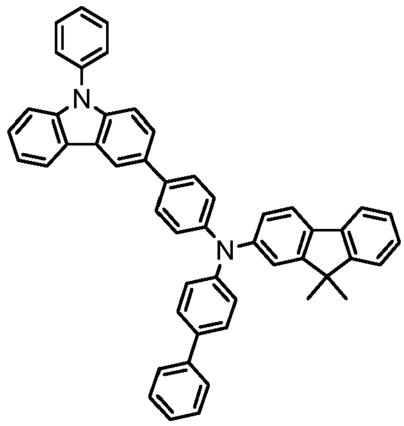

biphenyl-4-yl(9,9-diphenyl-9H-fluoren-2-yl)-[4-(9-phenyl-9H-carbazol-3-yl)phenyl]-amine, CAS 1242056-42-3,

F2 is

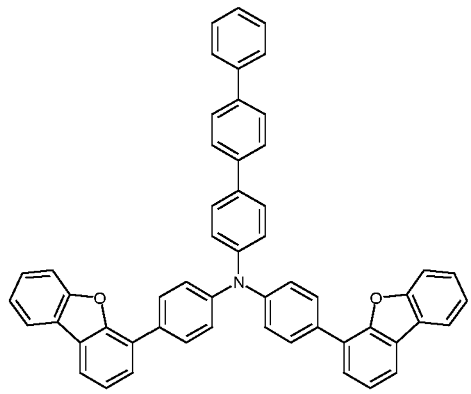

N,N-bis(4-(dibenzo[b,d]furan-4-y|)pheny|)-[1,1':4',1"-terpheny|]-4-amine, CAS 1198399-61-9;

F3 is

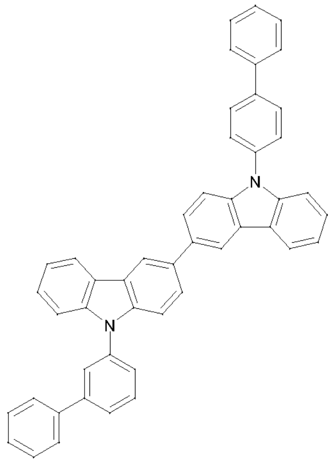

9-([1,1'-biphenyl]-3-y|)-9'-([1,1'-biphenyl]-4-yl)-9H,9'H-3,3'-bicarbazole, CAS 1643479-47-3;

F4 is

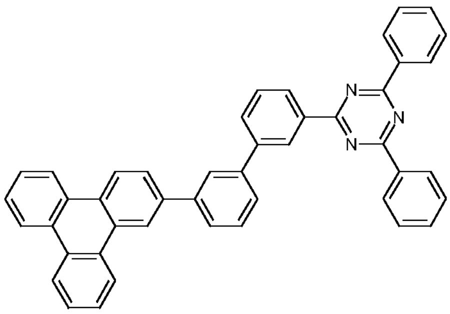

2,4-diphenyl-6-(3'-(triphenylen-2-yl)-[1,1'-biphenyl]-3-yl)-1,3,5-triazine, 1638271-85-8;

PD-2 is

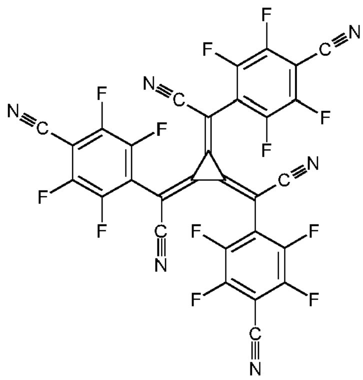

4,4',4"-((1E,1'E,1"E)-cyclopropane-1,2,3-triylidenetris (cyanomethanylylidene))tris(2,3,5,6-tetrafluorobenzonitrile), CAS 1224447-88-4.

H06 is an emitter host and DB-200 is a blue fluorescent emitter dopant, both commercially available from SFC, Korea.

Exemplary ETL matrix compounds M1 and M2 have the following formulae:

M1 is

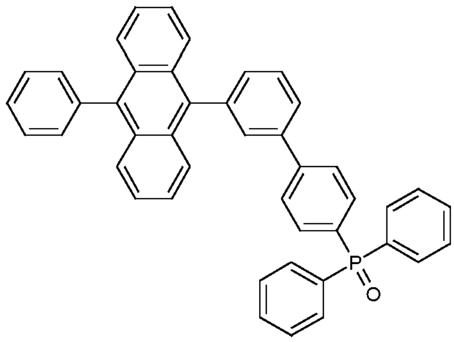

(i) ,

diphenyl(3'-(10-phenylanthracen-9-yl)-[1,1'-biphenyl]-4-yl)phosphine oxide, CAS 2138371-45-4, published in EP 3 232 490 and WO2017/178392,
and in the present invention serves as a comparative ETL matrix.

M2 is

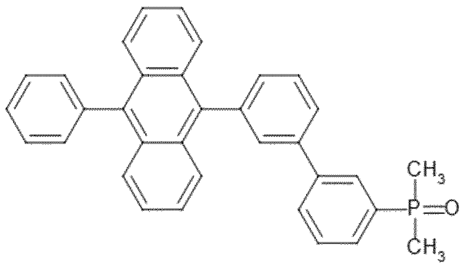

,

dimethyl(3'-(10-phenylanthracen-9-yl)-[1,1'-biphenyl]-3-yl)phosphine oxide, CAS 2101720-06-1, published in WO2017/102822, and in the present invention serves as the matrix component of the inventive semiconducting material.

Structure of the model device is shown in Table 1a

Table 1a

| layer | composition | c [wt%] | d [nm] |
|---|---|---|---|
| anode | Ag | 100 | 100 |
| HIL | F1:PD-2 | 92:8 | 10 |
| HTL | F1 | 100 | 117.5 |
| EBL | F2 | 100 | 5 |
| EML | H06:BD200 | 97:3 | 20 |
| HBL | F3:F4 | 70:30 | 5 |
| ETL | ETL matrix:n-dopant | 70:30 | 31 |
| EIL | Yb | 100 | 2 |
| cathode | Ag | 100 | 11 |
| cap layer | F1 | 100 | 75 |

Performance of the model device in terms of the operational voltage U, CIE coordinate y in the color space,

luminance, current density j, current efficiency $C_{eff}$, lifetime (defined as a time in which the luminance of the device operated at the current density j falls to 97 % of its initial value) and voltage rise d(U) after 100 hour operation at 85 °C is given in Table 1b.

Table 1b

| ETL composition | U [V] | CIE 1931 y | Luminance [$cd/m^2$] | j [$A/m^2$] | $C_{eff}$ [cd/A] | $LT_{97}$ [h] | dU (100 h) [%] at 85 °C |
|---|---|---|---|---|---|---|---|
| M1:C1 | 3.62 | 0.048 | 953 | 122 | 7.8 | 240 | 3.6 |
| M1:B1 | 5.09 | 0.047 | 932 | 196 | 4.8 | 34 | 8.5 |
| M1:E1 | 3.61 | 0.047 | 932 | 122 | 7.6 | 238 | 3.4 |
| M1:E2 | 3.57 | 0.047 | 932 | 123 | 7.6 | 233 | 2.7 |
| M2:C1 | 3.56 | 0.049 | 974 | 121 | 8.0 | 234 | 3.7 |
| M2:B1 | 3.54 | 0.049 | 974 | 121 | 8.0 | 221 | 1.4 |
| M2:E1 | 3.55 | 0.048 | 953 | 121 | 7.9 | 232 | 1.6 |
| M2:E2 | 3.55 | 0.048 | 953 | 122 | 7.8 | 242 | 1.8 |

In comparison with n-doped ETL materials comprising state-of-art compound C1 and/or triaryl phosphine oxide matrices, the selection of divalent metal salts in combination with a dialkyl phosphine oxide matrix brings improved operational voltage stability at elevated temperatures.

## Claims

1. Semiconducting material comprising:

   (i) at last one metal complex or metal salt comprising a divalent metal; and
   (ii) at least one matrix compound; **characterized in that** said matrix compound comprises a dialkylphosphine oxide group.

2. Semiconducting material according to claim 1, wherein the metal complex or metal salt is a borate complex or borate salt comprising at least one borate anion.

3. Semiconducting material according to claim 1 or 2, wherein the divalent metal ion is selected from $Ca^{2+}$, $Sr^{2+}$ and $Mg^{2+}$.

4. Semiconducting material according to any of claims 2 or 3, wherein the metal complex or metal salt has the following formula (I)

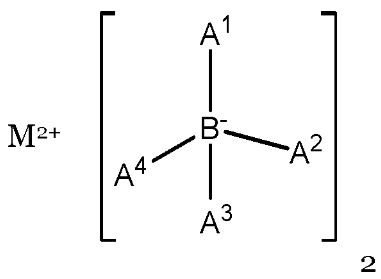

Formula (I)

   wherein M is the divalent metal ion, each of $A^1$- $A^4$ is independently selected from H, substituted or unsubstituted $C_6$-$C_{20}$ aryl and substituted or unsubstituted $C_2$-$C_{20}$ heteroaryl.

5. Semiconducting material according to claim 4, wherein at least one, alternatively at least two from $A^1$ to $A^4$ are nitrogen-containing heteroaryl.

**6.** Semiconducting material according to claim 5, wherein the nitrogen-containing heteroaryl is pyrazolyl.

**7.** Semiconducting material according to any of the preceding claims, wherein the matrix compound has the following formula (1).

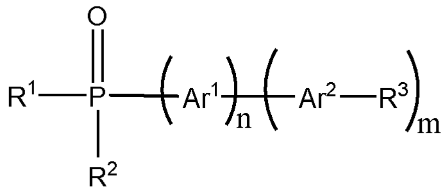

(1)

wherein $R^1$ and $R^2$ are each independently selected from $C_1$ to $C_{16}$ alkyl;
$Ar^1$ is selected from $C_6$ to $C_{14}$ arylene or $C_3$ to $C_{12}$ heteroarylene;
$Ar^2$ is independently selected from $C_{14}$ to $C_{40}$ arylene or $C_8$ to $C_{40}$ heteroarylene; $R^3$ is independently selected from H, $C_1$ to $C_{12}$ alkyl or $C_{10}$ to $C_{20}$ aryl;
wherein each of $Ar^1$, $Ar^2$ and $R^3$ may each independently be unsubstituted or substituted with at least one $C_1$ to $C_{12}$ alky group;
n is 0 or 1; and
m is 1 in case of n = 0; and m is 1 or 2 in case of n = 1.

**8.** Semiconducting material according to claim 7, wherein $Ar^1$ is selected from a group consisting of phenylene, biphenylene, naphthylene, fluorenylene, pyridylene, quinolinylene and pyrimidinylene.

**9.** Semiconducting material according to claim 7 or 8, wherein $Ar^2$ is selected from a group consisting of napthylene, fluorenylene, anthracenylene, pyrenylene, phenanthrylene, carbazoylene, benzo[c]acridinylene, dibenzo[c,h]acridinylene, dibenzo[a,j]acridinylene or from a group of the following formulas (IVa) to ( IVm)

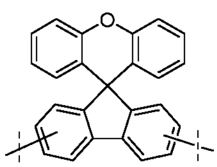 , 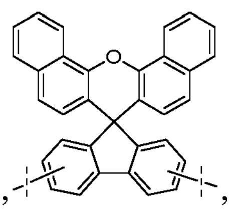 , 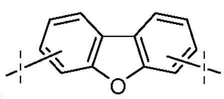 , 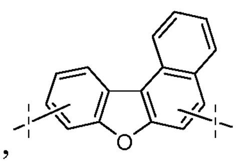 , 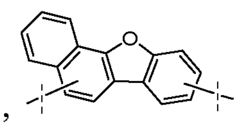

(IVa) (IVb) (IVc) (IVd) (IVe)

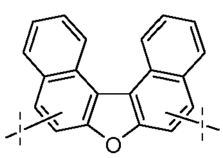 , 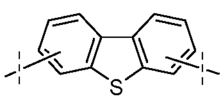 , 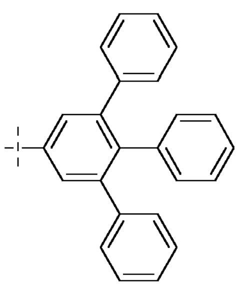 , 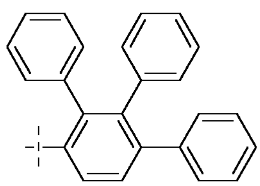

(IVf) (IVg) (IVh) (IVi)

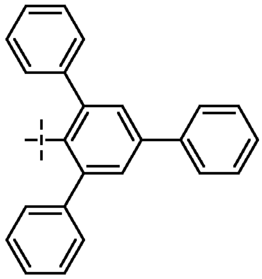,
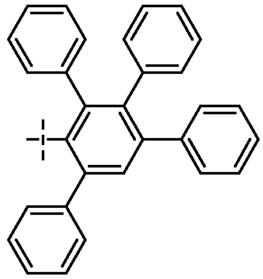,
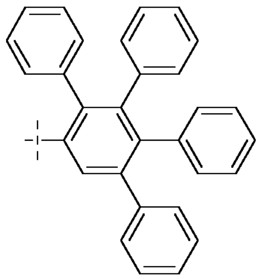

(IVj) (IVk) (IVl)

and

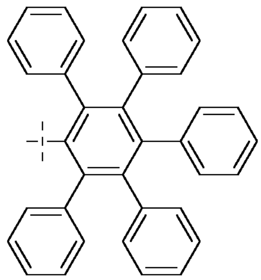

(IVm).

**10.** Semiconducting material according to any of the preceding claims wherein the matrix compound is selected from one of the following compounds a to g.

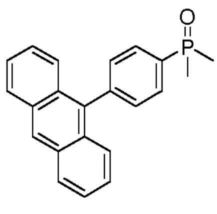
(a)
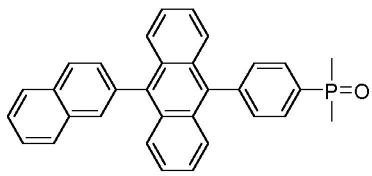
(b)

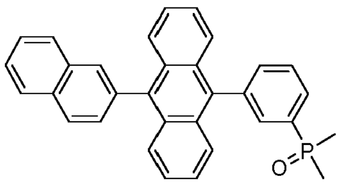
(c)
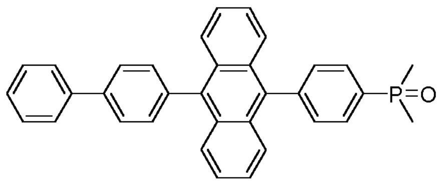
(d)

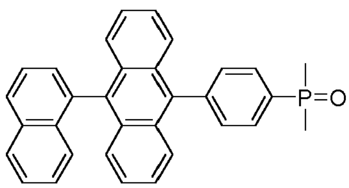
(e)
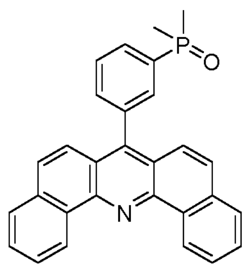
(f)

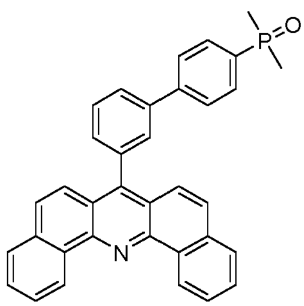

(g).

**11.** Semiconducting material according to any of the preceding claims, wherein the matrix compound is an electron transport matrix compound.

**12.** Electronic device comprising a semiconducting layer, said layer comprising the semiconducting material according to any of the preceding claims.

**13.** Electronic device according to claim 12 wherein the electronic device is an organic electronic device.

**14.** Electronic device according to any of the claims 12 or 13, wherein the organic semiconducting layer is an electron transport layer.

**15.** Method for preparing the semiconducting material according to any of the claims 1 to 11, the method comprising the steps

(i) co-evaporating the divalent metal salt or divalent metal complex and the matrix material; and
(ii) co-depositing the divalent metal salt or divalent metal complex and the matrix compound.

## Patentansprüche

**1.** Halbleitermaterial, umfassend:

(i) mindestens einen Metallkomplex oder ein Metallsalz, der/das ein zweiwertiges Metall umfasst; und
(ii) mindestens eine Matrixverbindung, **dadurch gekennzeichnet, dass** die Matrixverbindung eine Dialkylphosphinoxidgruppe umfasst.

**2.** Halbleitermaterial nach Anspruch 1, wobei der Metallkomplex oder das Metallsalz ein Boratkomplex oder ein Boratsalz ist, der/das mindestens ein Boratanion umfasst.

**3.** Halbleitermaterial nach Anspruch 1 oder 2, wobei das zweiwertige Metallion aus $Ca^{2+}$, $Sr^{2+}$ und $Mg^{2+}$ ausgewählt ist.

**4.** Halbleitermaterial nach einem der Ansprüche 2 oder 3, wobei der Metallkomplex oder das Metallsalz die folgende Formel (I) aufweist:

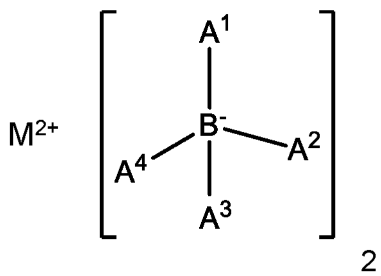

Formel (I)

wobei M das zweiwertige Metallion ist, jedes von $A^1$ - $A^4$ unabhängig aus H, substituiertem oder unsubstituiertem $C_6$-$C_{20}$-Aryl und substituiertem oder unsubstituiertem $C_2$-$C_{20}$-Heteroaryl ausgewählt ist.

**5.** Halbleitermaterial nach Anspruch 4, wobei mindestens eines, alternativ mindestens zwei von $A^1$ bis $A^4$ stickstoffhaltiges Heteroaryl sind.

**6.** Halbleitermaterial nach Anspruch 5, wobei das stickstoffhaltige Heteroaryl Pyrazolyl ist.

**7.** Halbleitermaterial nach einem der vorhergehenden Ansprüche, wobei die Matrixverbindung die folgende Formel (1) aufweist:

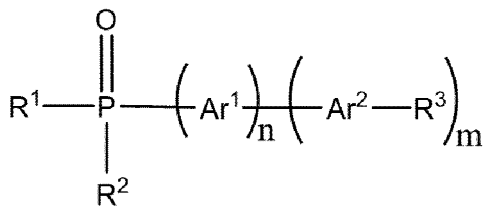

(1)

wobei $R^1$ und $R^2$ jeweils unabhängig aus $C_1$ bis $C_{16}$-Alkyl ausgewählt sind;
$Ar^1$ aus $C_6$ bis $C_{14}$-Arylen oder $C_3$ bis $C_{12}$-Heteroarylen ausgewählt ist;
$Ar^2$ unabhängig aus $C_{14}$ bis $C_{40}$-Arylen oder $C_8$ bis $C_{40}$-Heteroarylen ausgewählt ist;
$R^3$ unabhängig aus H, $C_1$ bis $C_{12}$-Alkyl oder $C_{10}$ bis $C_{20}$-Aryl ausgewählt ist;
wobei jedes von $Ar^1$, $Ar^2$ und $R^3$ jeweils unabhängig unsubstituiert oder mit mindestens einer $C_1$ bis $C_{12}$-Alkylgruppe substituiert sein kann;
n 0 oder 1 ist; und
m 1 im Falle von n = 0 ist; und m 1 oder 2 im Falle von n = 1 ist.

**8.** Halbleitermaterial nach Anspruch 7, wobei $Ar^1$ aus einer Gruppe ausgewählt ist, die aus Phenylen, Biphenylen, Naphthylen, Fluorenylen, Pyridylen, Chinolinylen und Pyrimidinylen besteht.

**9.** Halbleitermaterial nach Anspruch 7 oder 8, wobei $Ar^2$ aus einer Gruppe ausgewählt ist, die aus Napthylen, Fluorenylen, Anthracenylen, Pyrenylen, Phenanthrylen, Carbazoylen, Benzo[c]acridinylen, Dibenzo[c,h]acridinylen, Dibenzo[a,j]acridinylen oder aus einer Gruppe der folgenden Formeln (IVa) bis (IVm) besteht:

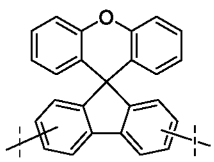 , 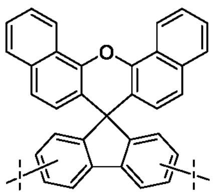 , 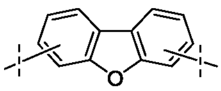 , 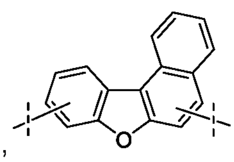 , 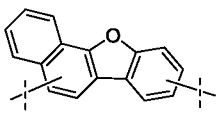

(IVa) (IVb) (IVc) (IVd) (IVe)

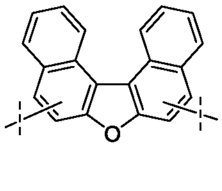 , 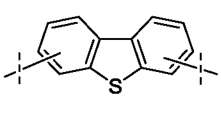 , 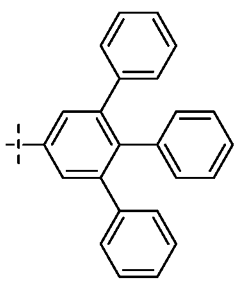 , 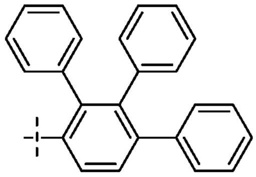

(IVf) (IVg) (IVh) (IVi)

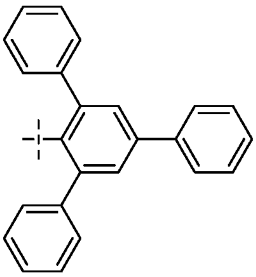

,

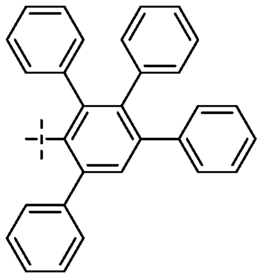

,

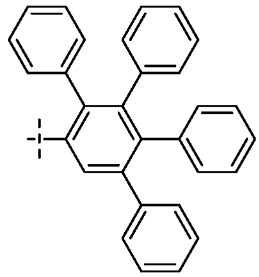

(IVj) (IVk) (IVl)

und

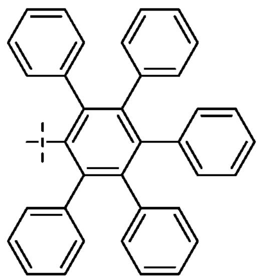

(IVm).

**10.** Halbleitermaterial nach einem der vorhergehenden Ansprüche, wobei die Matrixverbindung aus einer der folgenden Verbindungen a bis g ausgewählt ist:

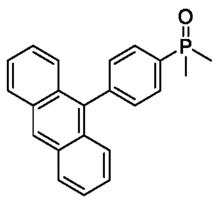

(a)

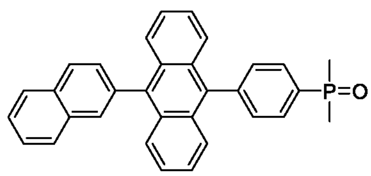

(b)

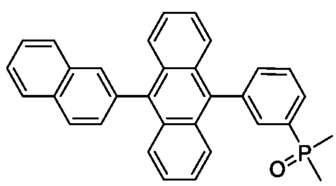

(c)

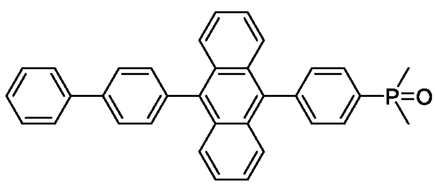

(d)

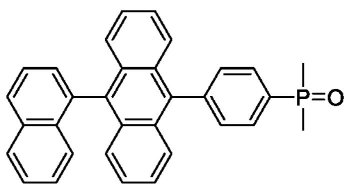

(e)

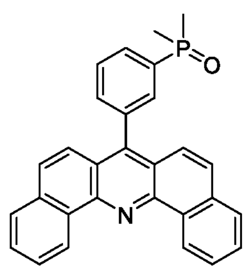

(f)

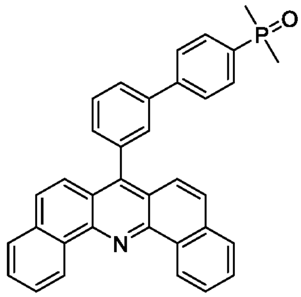

(g).

11. Halbleitermaterial nach einem der vorhergehenden Ansprüche, wobei die Matrixverbindung eine Elektronentransportmatrixverbindung ist.

12. Elektronische Vorrichtung, umfassend eine Halbleiterschicht, wobei die besagte Schicht das Halbleitermaterial nach einem der vorhergehenden Ansprüche umfasst.

13. Elektronische Vorrichtung nach Anspruch 12, wobei die elektronische Vorrichtung eine organische elektronische Vorrichtung ist.

14. Elektronische Vorrichtung nach einem der Ansprüche 12 oder 13, wobei die organische Halbleiterschicht eine Elektronentransportschicht ist.

15. Verfahren zur Herstellung des Halbleitermaterials nach einem der Ansprüche 1 bis 11, wobei das Verfahren die folgenden Schritte umfasst:

    (i) gemeinsames Verdampfen des zweiwertigen Metallsalzes oder des zweiwertigen Metallkomplexes und des Matrixmaterials; und
    (ii) gemeinsames Abscheiden des zweiwertigen Metallsalzes oder des zweiwertigen Metallkomplexes und der Matrixverbindung.

**Revendications**

1. Matériau semi-conducteur comprenant :

    (i) au moins un complexe métallique ou sel métallique comprenant un métal divalent ; et
    (ii) au moins un composé matriciel ; **caractérisé en ce que** ledit composé matriciel comprend un groupe oxyde de dialkylphosphine.

2. Matériau semi-conducteur selon la revendication 1, dans lequel le complexe métallique ou le sel métallique est un complexe de borate ou un sel de borate comprenant au moins un anion borate.

3. Matériau semi-conducteur selon la revendication 1 ou 2, dans lequel l'ion métallique divalent est sélectionné parmi $Ca^{2+}$, $Sr^{2+}$ et $Mg^{2+}$.

4. Matériau semi-conducteur selon l'une quelconque des revendications 2 et 3, dans lequel le complexe métallique ou le sel métallique répond à la formule (I) suivante

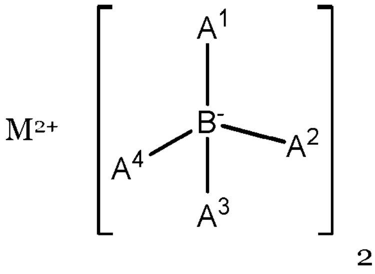

formule (I)

dans laquelle M est l'ion métallique divalent, chacun des groupes $A^1$ à $A^4$ est sélectionné indépendamment parmi H, un $C_6$-$C_{20}$ aryle substitué ou non substitué, ou un $C_2$-$C_{20}$ hétéroaryle substitué ou non substitué.

5. Matériau semi-conducteur selon la revendication 4, dans lequel au moins un, et en variante au moins deux groupes parmi $A_1$ à $A_4$ sont des hétéroaryles contenant de l'azote.

6. Matériau semi-conducteur selon la revendication 5, dans lequel l'hétéroaryle contenant de l'azote est un pyrazolyle.

7. Matériau semi-conducteur selon l'une quelconque des revendications précédentes, dans lequel le composé matriciel répond à la formule (1) suivante

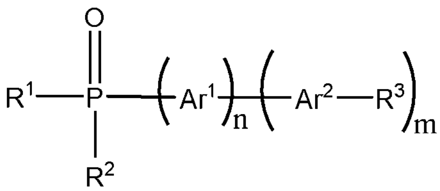

(1)

dans laquelle $R^1$ et $R^2$ sont sélectionnés chacun indépendamment parmi les $C_1$-$C_{16}$ alkyles ;
$Ar^1$ est sélectionné parmi les $C_6$-$C_{14}$ arylènes ou les $C_3$-$C_{12}$ hétéroarylènes ;
$Ar^2$ est sélectionné indépendamment parmi les $C_{14}$-$C_{40}$ arylènes ou les $C_8$-$C_{40}$ hétéroarylènes ;
$R^3$ est sélectionné indépendamment parmi H, les $C_1$-$C_{12}$ alkyles et les $C_{10}$-$C_{20}$ aryles ; dans lequel chacun des groupes $Ar^1$, $Ar^2$ et $R^3$ peut être indépendamment non substitué ou substitué par au moins un groupe $C_1$-$C_{12}$ alkye ;
n est 0 ou 1 ; et
m est 1 dans le cas où n = 0 ; et
m est 1 ou 2 dans le cas où n = 1.

8. Matériau semi-conducteur selon la revendication 7, dans lequel $Ar^1$ est sélectionné dans le groupe constitué par les phénylènes, les biphénylènes, les naphthylènes, les fluorénylènes, les pyridylènes, les quinolinylènes et les pyrimidinylènes.

9. Matériau semi-conducteur selon la revendication 7 ou 8, dans lequel $Ar^2$ est sélectionné dans le groupe constitué par les napthylènes, les fluorénylènes, les anthracénylènes, les pyrénylènes, les phénanthrylènes, les carbazoylènes, les benzo[c]acridinylènes, les dibenzo[c,h]acridinylènes et les dibenzo[a,j]acridinylènes, ou dans le groupe répondant aux formules (IVa) à (IVm) suivantes

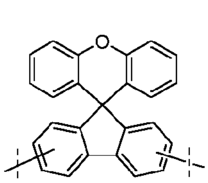,
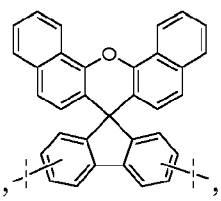,
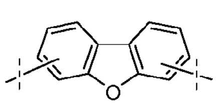,
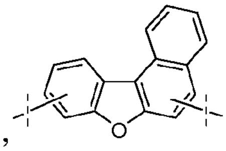,
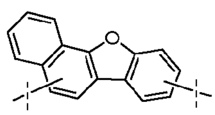

(IVa) (IVb) (IVc) (IVd) (IVe)

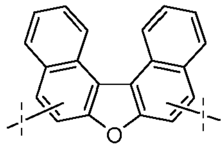, 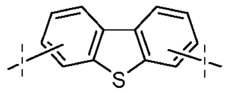, 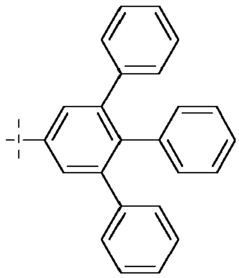, 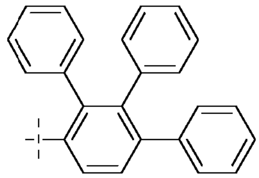

(IVf) (IVg) (IVh) (IVi)

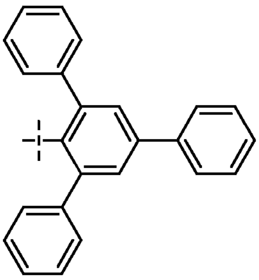, 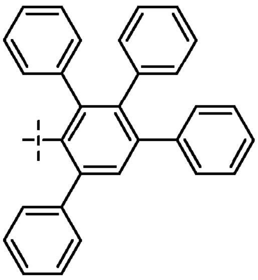, 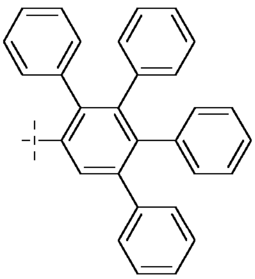

(IVj) (IVk) (IVl)

et

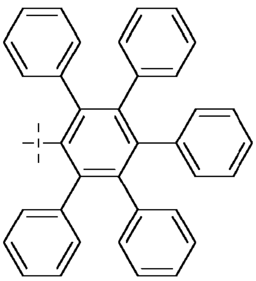

(IVm).

**10.** Matériau semi-conducteur selon l'une quelconque des revendications précédentes, dans lequel le composé matriciel est sélectionné parmi l'un des composés a à g suivants

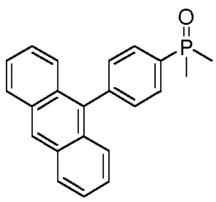 (a) 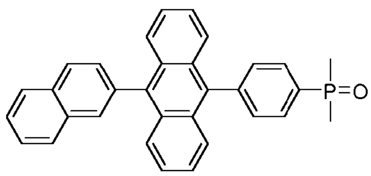 (b)

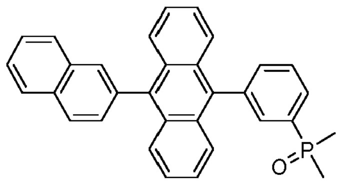 (c) 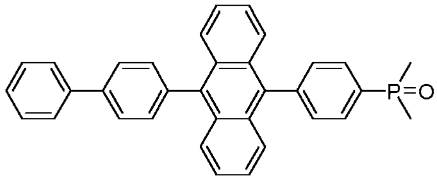 (d)

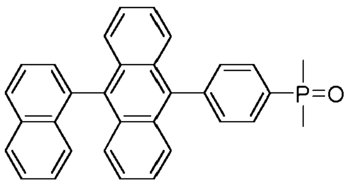 (e) 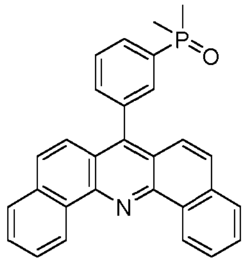 (f)

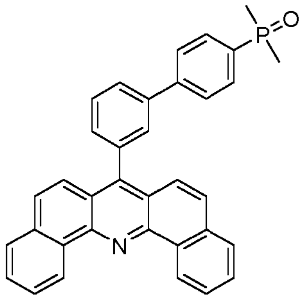 (g).

**11.** Matériau semi-conducteur selon l'une quelconque des revendications précédentes, dans lequel le composé matriciel est un composé matriciel de transport d'électrons.

**12.** Dispositif électronique comprenant une couche de semi-conducteur, ladite couche comprenant le matériau semi-conducteur selon l'une quelconque des revendications précédentes.

**13.** Dispositif électronique selon la revendication 12, dans lequel le dispositif électronique est un dispositif électronique organique.

**14.** Dispositif électronique selon l'une quelconque des revendications 12 et 13, dans lequel la couche de semi-conducteur organique est une couche de transport d'électrons.

**15.** Procédé de préparation du matériau semi-conducteur selon l'une quelconque des revendications 1 à 11, le procédé comprenant les étapes

(i) de co-évaporation du sel métallique divalent ou du complexe métallique divalent et du matériau matriciel ; et
(ii) de co-dépôt du sel métallique divalent ou du complexe métallique divalent et du composé matriciel.

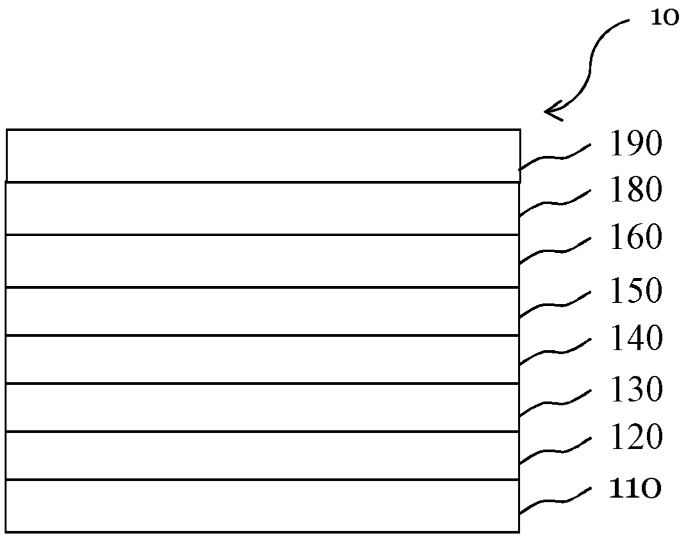
10
190
180
160
150
140
130
120
110

Fig.1

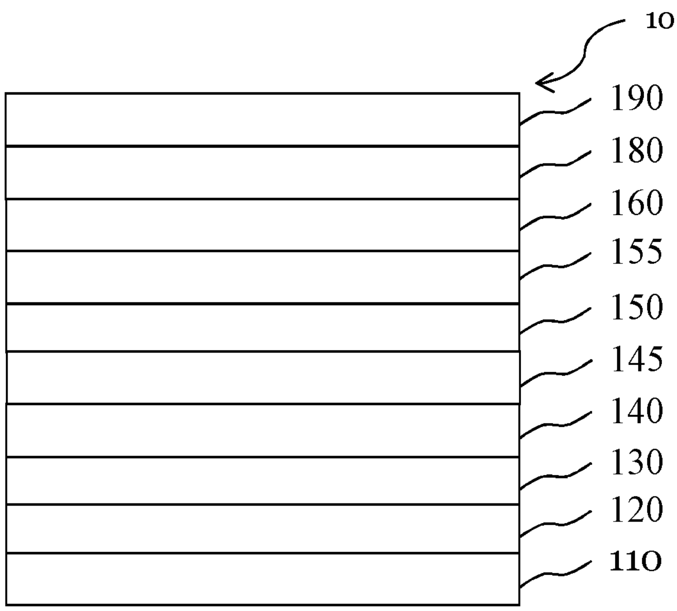
10
190
180
160
155
150
145
140
130
120
110

Fig.2

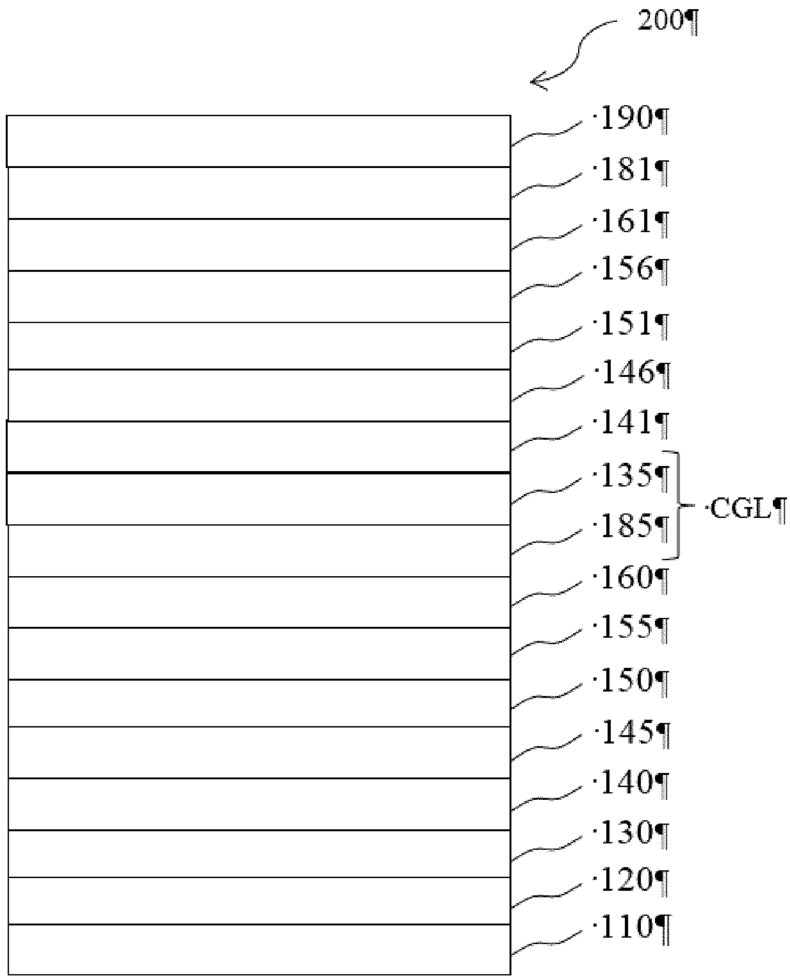
200¶
·190¶
·181¶
·161¶
·156¶
·151¶
·146¶
·141¶
·135¶
·185¶
·CGL¶
·160¶
·155¶
·150¶
·145¶
·140¶
·130¶
·120¶
·110¶

Fig.3¶

¶

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 2786433 A1
- WO 2017089399 A
- EP 2722908 A1
- EP 1970371 A1
- WO 2013079217 A1
- EP 3232490 A
- WO 2017178392 A
- WO 2017102822 A


### Non-patent literature cited in the description


- **YASUHIKO SHIROTA ; HIROSHI KAGEYAMA.** *Chem. Rev.,* 2007, vol. 107, 953-1010
- *CHEMICAL ABSTRACTS,* 2138371-45-4
- *CHEMICAL ABSTRACTS,* 2101720-06-1